# EUROPÄISCHE PATENTSCHRIFT

(11) **EP 3 907 754 B1**
(45) Veröffentlichungstag und Bekanntmachung des Hinweises auf die Patenterteilung: **26.04.2023**
(21) Anmeldenummer: 21172261.6
(22) Anmeldetag: 05.05.2021
(51) Int. Cl.: H01L 21/67

(54) **VERFAHREN ZUR BEARBEITUNG VON SUBSTRATEN, INSBESONDERE VON WAFERN, MASKEN ODER FLAT PANEL DISPLAYS, MIT EINER MASCHINE DER HALBLEITERINDUSTRIE**
METHOD FOR PROCESSING SUBSTRATES, IN PARTICULAR WAFERS, MASKS OR FLAT PANEL DISPLAYS, WITH A SEMICONDUCTOR INDUSTRY MACHINE
PROCÉDÉ DE TRAITEMENT DES SUBSTRATS, EN PARTICULIER DES PLAQUETTES, DES MASQUES OU DES PANNEAUX D'AFFICHAGE PLATS, AU MOYEN D'UNE MACHINE DE L'INDUSTRIE DES SEMI-CONDUCTEURS

(30) Priorität: 05.05.2020 DE 102020112146
(43) Veröffentlichungstag der Anmeldung: 10.11.2021
(73) Patentinhaber: Integrated Dynamics Engineering GmbH, 65479 Raunheim (DE)
(72) Erfinder: BIRKNER, Andreas, 07743 Jena (DE)
(74) Vertreter: Blumbach · Zinngrebe Patentanwälte PartG mbB

(56) Entgegenhaltungen:
- KR-B1- 102 027 951
- US-A1- 2007 282 480
- US-A1- 2019 187 555
- US-A1- 2019 188 840
- US-A1- 2019 252 213
- US-A1- 2019 382 213
- US-A2- 2008 091 297

## Beschreibung

Die Erfindung betrifft ein Verfahren zur Bearbeitung von Substraten, insbesondere von Wafern, Masken oder Flat Panel Displays, mit einer Maschine der Halbleiterindustrie, wobei ein rechnerunterstütztes Verfahren zum Bestimmen der Präsenz und/oder der Position und/oder der Orientierung des Substrates zur Anwendung kommt. Die Erfindung betrifft ferner ein zur Ausführung des Verfahrens ausgebildetes System.

### Hintergrund der Erfindung

Zur Bearbeitung von Substraten, insbesondere von Wafern, Masken oder Flat Panel Displays, können unterschiedliche Maschinen der Halbleiterindustrie eingesetzt werden.

Dabei ist es oft notwendig, die Präsenz und/oder die Position und/oder die Orientierung des Substrates beziehungsweise der Substrate, welche bearbeitet werden sollen, an verschiedenen Stellen der Maschine festzustellen. Diese Information wird auf verschiedene Weise benötigt, beispielsweise um beim Aufnehmen von Substraten aus einer Kassette festzustellen, ob und/oder wo sich Substrate in der Kassette befinden, und/oder ob sich diese Substrate in der Kassette in einer Lage befinden, in welcher sie beispielsweise ein Roboter zur Aufnahme des Substrates erwartet, oder ob sie eine Fehlablage haben, wo beispielsweise zwei Substrate in einem Slot der Kassette liegen anstelle von einem Substrat ("double slotted"), und/oder ob ein Substrat eine Fehllage aufweist, wo es über mehrere Slots in der Kassette liegt anstelle von einem Slot. Weiterhin ist es oft notwendig zu prüfen, wenn ein Substrat in einer Kassette abgelegt werden soll, ob der dafür vorgesehene Slot frei ist, oder ob er schon belegt ist. In ähnlicher Weise gilt dies für weitere mögliche Stationen, wo sich ein Substrat oder mehrere Substrate in der Maschine befinden kann beziehungsweise befinden können, und soweit es zutreffend ist, für den jeweiligen Typ der Station, beispielsweise für Auflagen, für Bearbeitungsstationen, wie beispielsweise "Chucks", Verfahreinheiten wie xy-Tische, Einheiten zur Änderung der Orientierung eines Substrates wie "Prealigner" oder "Substrat-Flipper" oder Substrat-Rotatoren, Substrat-Zwischenspeicher, Substrathalter, Roboter oder Endeffektoren von Robotern. Dabei kann es notwendig sein, nicht nur die Präsenz und/oder Lage und/oder die Orientierung der Substrate selber festzustellen, sondern auch die Präsenz und/oder Orientierung und/oder die Lage der Bearbeitungsstation selber.

Weiterhin kann es sein, dass die Substrate zusätzliche Teile enthalten, beispielsweise kann eine Maske ein Pellicle enthalten, wobei die Maske mit Pellicle in verschiedenen Orientierungen und/oder Lagen in Kassetten und/oder auf Auflagen und/oder auf Bearbeitungsstationen vorkommen können. Es kann notwendig sein, diese Lage und/oder Orientierung der Maske mit einem Pellicle festzustellen, um beispielsweise zu kontrollieren, ob ein Roboter mit einem Greifer oder Endeffektor die Maske mit der konkreten Lage des Pellicles aufnehmen kann, und/oder ob sich die Maske mit Pellicle in der richtigen Orientierung für die Bearbeitung auf einer Bearbeitungsstation befindet.

Weiterhin können Substrate auch mit weiteren zusätzlichen Komponenten ausgestattet sein. Beispielsweise können Wafer in einer Kassette auf speziellen Wafer-Haltern montiert sein, wenn sie beispielsweise auf Grund zu geringer Dicke eine zu starke Durchbiegung für den Transport oder die Bearbeitung aufweisen würden, weiterhin können Pellicle und auf Wafer und auch Flat-Panel-Displays mit zusätzlichen Bauteilen ausgestattet sein, wie beispielsweise Messmittel oder Kalibrierungemittel, welche für die Kalibrierung der Maschine notwendig sein können. Ähnlich wie bei dem Pellicle auf der Maske kann es auch hier notwendig sein, Lage und/oder Orientierung dieser Bauteile zu erkennen.

Bei vielen Maschinen in der Halbleiterindustrie erfolgt die Bearbeitung zumindest teilweise in Vakuumkammern, es versteht sich, dass die erfindungsgemäßen Verfahren auch unter Vakuumbedingungen eingesetzt werden können, sofern die benötigten Komponenten vakuumtauglich ausgeführt sind.

Die Erkennung der Präsenz und/oder der Lage und/oder der Orientierung von Substraten wird oft in der der Maschine zugeordneten Steuerung oder Bedienung zur Steuerung und Kontrolle der Bearbeitung der mit der Präsenz und/oder der Lage und/oder der Orientierung von Substraten zusammenhängenden Abläufe eingesetzt.

Die Erkennung der Präsenz und/oder der Lage und/oder der Orientierung von Substraten wird oft mittels von mindestens einem Sensor durchgeführt, wobei der mindestens eine Sensor in verschiedenen Technologien ausgeführt sein kann, beispielsweise können das optische Sensoren sein (Lichtschranken, Reflexlichtschranken), kapazitive Sensoren, induktive Sensoren durchgeführt, Scannende Sensoren. Dabei ist es notwendig, dass die Sensoren die Substrate physikalisch erkennen können (eine Maske beispielsweise kann aus transparentem Material bestehen, was besondere Anforderungen an die Erkennung mit einem optischen Sensor stellt), es müssen weiterhin konstruktive Gegebenheiten der Maschine berücksichtigt werden (wie Entfernungen zwischen Sensor und Substrat, was insbesondere bei größeren Entfernungen und höherer erforderlicher Genauigkeit besondere Anforderungen an den Sensor und an die Einrichtung und Justage der Sensoren und Toleranzen der einbezogenen Bauteile stellen kann), oder es müssen scannende Bewegungen eingeführt werden (um beispielsweise eine Kassette mit mehreren Substraten, oder eine Maske mit einem Pellicle, zu scannen, wobei eine scannenden Bewegung im Bewegungsablauf die Produktivität eines Roboters und damit der Maschine verringern kann). Weiterhin müssen ausreichend viele Sensoren vorhanden sein, um alle erforderlichen Positionen und/oder Lagen und/oder Orientierungen von Substraten zu erkennen.

Die oben dargestellten Nachteile der Erkennung von Lage und/oder Orientierung und/oder Position von Substraten führen zur verschiedenen Problemen im Zusammenhang mit Maschinen der Halbleiterindustrie.

Ein weiterer Aspekt ist das Trainieren oder Anlernen, auch "Teach-In" genannt, des Handlingsystems. Zum Handlingsystem gehören beispielsweise Roboter, wobei es gängig ist, dass mittels eines Roboters, welcher einen sogenannten Endeffektor zum Greifen und Ablegen eines Substrates aufweist, die zu bearbeitenden Substrate, insbesondere Wafer, Masken oder Flat Panel Displays, von einer Bearbeitungsstation zu einer anderen bewegt werden.

Derartige Roboter bewegen den Endeffektor in der Regel in mehreren Raumrichtungen und es ist bei einer Anlage oder Maschine zur Bearbeitung von Halbleiterbauelementen nötig, den Roboter anzulernen, also die Trajektorie einer Bewegungskurve einzuspeichern.

Bei dem sogenannten "Teach-In" wird ein Roboter mit einem Bewegungsablauf angelernt und/oder mechanisch justiert, welchen er sodann im Betrieb der Anlage weiter ausführt. Insbesondere wird beim Teach-In eine Zielposition angelernt, in welcher das Substrat vom Roboter abgelegt wird. Das Teach-in wird bei vielen Robotern manuell bei angeschalteten Motorachsen durchgeführt. Zumeist erfolgt der Teach-In-Vorgang unter optischer Kontrolle durch einen Bediener und die Bewegungskurve wird durch eine Vielzahl kleinerer Einzelschritte, insbesondere der Radial- und Theta-Bewegungen, durchgeführt. Oft sind dabei zwei Bediener erforderlich, da beim Teach-In-Vorgang zwei oder mehr Richtungen oder Freiheitsgrade optisch überwacht werden müssen, um Kollisionen zu vermeiden.

Bei Fehlern des Bedieners können größere Schäden entstehen. Zudem ist die Sicht des Bedieners, der die Bewegung des Roboters optisch überwacht, vielfach eingeschränkt. Dies gilt insbesondere in Vakuum-Kammern.

Weiterhin ist der Vorgang des Teach-In, oder der vorzugsweise regelmäßig durchgeführten Kontrolle des korrekten Teach-In zumeist damit verbunden, dass die Anlage geöffnet werden muss, wodurch sie außer Betrieb genommen werden muss, was entsprechende Ausfallzeiten erzeugt. Es muss dazu das sogenannte Mini-Environment der Anlage geöffnet werden, wodurch die Anlage verunreinigt werden kann, was wiederum zusätzliche Ausfallzeiten der Maschine verursacht, um danach die erforderliche Sauberkeit in der Anlage wiederherzustellen.

Ein ungenaues Teach-In führt kann zu erhöhter Partikelgenerierung führen und damit zu verringerter Ausbeute des Prozesses, in welchem die Anlage verwendet wird. Ungenaues Teach-In kann ebenfalls zu Fehlern durch zu große Fehlablagen des Substrats führen.

Aus dem Dokument EP 19 206 746.0 der Anmelderin sind Verfahren zum Anlernen oder Kontrollieren eines Roboters zum Bewegen eines Wafers oder einer Maske oder eines Flat-Panel Displays bekannt, wobei Kameras und eine regelbasierende Bildverarbeitung genutzt werden zum Erkennen von Objekten, insbesondere von Substraten wie Masken (Reticle), Wafern oder Flat Panel Displays.

Diese Verfahren können zusammen mit oder in Maschinen oder Anlagen der Halbeiterindustrie, welche zur Prozessierung von Wafern, Masken oder Flat Panel Displays verwendet werden, genutzt werden.

Dabei soll mittels an den Maschinen oder Anlagen angebrachter Kameras, etwa einer an einem Endeffektor angebrachten Kamera oder auch mittels am Ablageort angebrachter Kameras oder an anderer Stelle angebrachter Kameras ermittelt werden, ob sich die besagten Objekte an einer bestimmten Stelle befinden.

So soll beispielsweise die Belegung einer Kassette mit Substraten ermittelt werden können. Ferner soll ermittelt werden können, in welcher Orientierung hinsichtlich der jeweils drei translatorischen und rotatorischen Freiheitsgrade sich diese Objekte befinden, ob sie sich in einer vorbestimmten Position befinden, und in welcher Konfiguration diese Objekte vorliegen.

Hier stellt sich etwa die Frage, ob eine Maske mit oder ohne einem sogenannten "Pellicle" ausgebildet ist, und wenn ja, ob das Pellicle oben oder unten auf der Maske sitzt, ferner auch, in welcher Orientierung das Pellicle vorliegt.

Dabei erzeugt die Kamera Bilder, welche manuell /visuell ausgewertet werden können. Hierzu kann eine Bildverarbeitung genutzt werden.

Diese Art der Bildverarbeitung beruht auf dem Verfahren, geometrische Objekte, oder geometrische Eigenschaften von Objekten, oder auch Formen von Objekten zu erkennen, indem Regeln definiert werden, nach denen diese Eigenschaften von Objekten erkannt werden können.

Beispielsweise kann die Lage einer Objektkante dadurch bestimmt werden, dass die zu erkennende Kante eines Objektes einen Farbunterschied von der Kante zu einem Hintergrund aufweist, welcher durch die Bilderkennung dadurch erkannt wird, dass eine Regel definiert ist, welche die Farbwerte der Kante und des Hintergrundes definiert, und den Übergang der Farbwerte vom Objekt zum Hintergrund als einen Punkt der Kante definiert. Werden beispielswiese mehrere solche Regeln auf verschiedene Stellen eines Objektes angewandt, können damit auch mehrdimensionale Objekte auf ihre Form, ihre Lage, und ihre Anwesenheit bestimmt werden.

Dabei werden geeignete Regeln in diskreten vordefinierten Abschnitten des Bildes eines Objektes definiert. Die Bildverarbeitung kann dann demzufolge auch nur korrekt arbeiten, wenn sich das Objekt in diesen vordefinierten Abschnitten befindet. Nach diesem Verfahren arbeitende Systeme werden häufig auch als regelbasierende Verfahren bezeichnet.

Der Nachteil solcher regelbasierenden Verfahren ist es, dass durch die Regeln die in der betrieblichen Praxis auftretenden Schwankungen und Einflussfaktoren berücksichtigt werden müssen.

Dies kann sehr komplex werden, wenn verschiedene Einflussfaktoren zu berücksichtigen sind. So kann es beispielsweise vorkommen, dass bei der Erkennung eines Objektes wie beispielsweise einer Maske, oder der Bestimmung der Position oder der Größe des Objektes, verschiedene Beleuchtungsverhältnisse, verschiedene Farben der Objekte und des Hintergrundes, unterschiedliche Bildschärfen, beispielsweise auch infolge von auftretenden Vibrationen während der Bildaufnahme, Lichteinstreuungen aus der Umgebung oder auch Toleranzen der Position oder der Lage des Substrates zu berücksichtigen sind.

Diese Aufzählung ist rein beispielhaft zu sehen und wird nicht als vollständig erachtet. So können in komplexen Produktionsumgebungen weitere Einflussfaktoren hinzukommen. Erschwerend kann hinzutreten, dass auch noch zusätzliche Einflussfaktoren erst während der späteren Verwendung des Verfahrens in den Systemen hinzutreten können, beispielsweise im Jahresrhythmus variierende Lichtverhältnisse.

Dies kann zu sehr komplexen Regelwerken führen, in welchen die zumeist manuell erstellten Regeln aufgeführt werden. Allerdings sind diese mit steigender Komplexität immer aufwendiger zu definieren, und können zudem auch immer unzuverlässiger arbeiten, da die Anzahl der Regeln über die Kombination der verschiedenen Schwankungen sehr hoch werden kann und dadurch eine entsprechend hohe Anzahl von Fehlerquellen entstehen.

Weiterhin sind diese Regeln nicht oder kaum flexibel. So kann eine in einer definierten Regel nicht vorgesehene Schwankung, beispielsweise hervorgerufen durch eine sich ändernde Lichteinstreuung aus der Umgebung des Systems, leicht zu Fehlfunktionen der Bilderkennung führen.

Da zumeist die Regeln in diskreten vordefinierten Abschnitten des Bildes eines Objektes definiert sind, kann die Bildverarbeitung demzufolge nur dann korrekt arbeiten, wenn sich das Objekt in diesen vordefinierten Abschnitten befindet.

Weiterhin kann es auch vorkommen, dass - unabhängig von den Einflussfaktoren - über zumeist manuell erstellte Regeln eine Erkennung generell nicht sinnvoll oder möglich ist, weil von vornherein für die Erkennung eines Objektes zu viele Regeln benötigt werden.

Zwar ist beispielsweise aus der EP 1 366 867 B1 ein Verfahren zum Vermeiden von Kollisionen zwischen einem Roboter und wenigstens einem anderen Objekt bekannt, wobei eine Anhaltezeit für eine Roboterbewegung bestimmt wird und wobei eine Behinderungsüberprüfung mittels eines neuronalen Netzes geschieht.

Ferner ist aus der EP 3 409 230 B1 ein Verfahren zum Bewegen eines Roboterarms bekannt, wobei ein künstliches neuronales Netz zur Verfügung gestellt wird, welches genutzt wird, um einen optimalen Bewegungsablauf für einen Roboter im Zuge einer Ultraschalluntersuchung zu finden.

Schließlich ist aus der DE 10 2018 113 336 A1 ein Verfahren zum Verwenden mit einer Maschine bekannt, um für einen Roboter einen Koordinatenabgleich zwischen einem Maschinenkoordinatensystem der Maschine und einem Koordinatensystem einer Bildaufnahmeeinrichtung durchzuführen. Weiterhin offenbart US2007282480 eine Prozessmaschine, bei der unter Verwendung von Sensoren die Position des Wafers in der Prozesslinie unter Verwendung von neuronalem Netzwerklernen erfasst wird. US2019188840 offenbart ein System, in dem unter Verwendung von Bildern und neuronalen Faltungsnetzverarbeitungsfehlerinformationen auf einem Wafer in der Prozesslinie erfasst werden.

Aber auch mit diesen Verfahren ist es nicht möglich, die oben genannten Nachteile zu überwinden.

### Aufgabe der Erfindung

Die Erfinder haben sich die Aufgabe gestellt, ein Verfahren zur Bearbeitung von Substraten, insbesondere von Wafern, Masken oder Flat Panel Displays, mit einer Maschine der Halbleiterindustrie zur Verfügung zu stellen, welches ein einfacheres und besseres Anlernen und Bearbeiten dieser Substrate erlaubt.

Von daher wird es als wünschenswert angesehen, ein Verfahren zur Bearbeitung von Substraten und ein System anzugeben, welche die weiter oben genannten Nachteile vermeidet.

Das Verfahren soll dabei in Maschinen der Halbleiterindustrie zur Bearbeitung von Substraten, insbesondere von Wafern, Masken oder Flat Panel Displays, verwendet werden können, beispielsweise zur Bewegungssteuerung eines Roboters oder beispielsweise der Steuerung im Zusammenhang mit einer Erkennung basierend auf Bildern.

Das Verfahren soll es beispielsweise ermöglichen, zu erkennen, ob sich bestimmte Objekte an einer bestimmten Stelle befinden. Ferner soll ermittelt werden können, ob sich diese Objekte in einer Position befinden, in welcher sie bewegt oder prozessiert werden können.

Vorzugsweise soll dabei vermieden werden, dass für den Ablauf des Verfahrens manuell vielfältige Regeln und Bedingungen definiert werden müssen. Wünschenswert ist demnach also eine Abkehr von einem starren, regelbasierenden Verfahren hin zu einem Verfahren, welches eine hohe Flexibilität bei gleichzeitig niedrigem Aufwand bietet.

### Zusammenfassung der Erfindung

Die Aufgabe der Erfindung wird bereits durch ein Verfahren zur Bearbeitung von Substraten, insbesondere von Wafern, Masken oder Flat Panel Displays, mit einer Maschine der Halbleiterindustrie, sowie durch ein zur Ausführung dieses Verfahrens ausgebildetes System sowie ein Computerprogrammprodukt nach einem der unabhängigen Ansprüche gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft demnach ein Verfahren zur Bearbeitung eines Substrates, insbesondere eines Wafers, einer fotolithographischen Maske oder eines Flat Panel Displays, mit einer Maschine der Halbleiterindustrie, wobei ein künstliches neuronales Netz verwendet wird,
um die Präsenz und/oder die Position und/oder die Orientierung und/oder den Typ des Substrates zu ermitteln auf Basis von mindestens einem Bild, welches einen Ort in oder an der Maschine der Halbleiterindustrie oder in der Umgebung der Maschine darstellt, an dem sich ein Substrat bei einem Betrieb der Maschine der Halbleiterindustrie befinden kann,
wobei vorzugsweise das mindestens eine Bild von mindestens einer Aufnahmeeinheit aufgenommen wird,
und wobei durch das künstliche neuronale Netz
ein Informationsdatensatz umfassend eine Information über die ermittelte Präsenz und/oder Position und/oder Orientierung und/oder den Typ des Substrates
und/oder ein Steuerbefehl erzeugt wird und/oder ermöglicht wird, welcher dazu dient,
die Maschine der Halbleiterindustrie direkt zu steuern, oder von der Steuerung der Maschine verwendet wird,
oder an ein übergeordnetes Steuerungssystem weitergegeben wird,
oder an einen Bediener weitergegeben wird, der aus dieser Information Rückschlüsse für sein Handeln zur Bedienung der Maschine zieht,
oder diese Information an Steuerungen oder andere Bediener weitergibt,
oder für spätere oder weitere Auswertung gespeichert wird.

Das zumindest eine Bild wird dabei in digitalisierter Form von dem künstlichen neuronalen Netz erfasst und analysiert, um den Informationsdatensatz und/oder der Steuerbefehl zu erzeugen, mit welchem die Maschine der Halbleiterindustrie direkt oder unterstützend gesteuert, ausgerichtet, trainiert, und/oder kontrolliert wird.

Das Bearbeiten kann dabei das Transportieren eines Substrates zwischen zwei oder mehreren Stationen betreffen, beispielsweise einer Ablage oder eine Bearbeitungsstation, oder beispielsweise die Steuerung der Abläufe der Maschine.

Unter dem Begriff Maschine der Halbleiterindustrie sind allgemein Anlagen und Einrichtungen zu verstehen, die im Bereich der Halbleiterindustrie zum Einsatz kommen. So ist mit dem Begriff Maschine der Halbleiterindustrie auch ein Roboter bezeichnet oder umfasst, welcher ein bewegliches Element, bevorzugt einen Roboterarm und/oder einen Endeffektor, umfassen kann. Ferner wird unter dem Begriff Maschine der Halbleiterindustrie auch eine Verfahreinheit verstanden, welche zum Bewegen oder Transportieren des Substrates verwendet werden kann. Ferner können darunter auch Auflagen, Bearbeitungsstationen oder Kassetten verstanden werden.

Die Maschine der Halbleiterindustrie kann demzufolge Mittel umfassen zum Greifen, Haltern, Transportieren und/oder Ablagen eines Substrates.

Die Maschine der Halbleiterindustrie kann dabei auch in Verbindung mit oder in einer Vakuumkammer zum Einsatz kommen, etwa in Verbindung mit oder in einer Vakuumkammer für Wafer, Masken oder Flat Panel Display, oder auch mit oder an einem dort installierten Vakuum-Roboter, Vakuum-Stage oder Vakuum-Chuck.

Im Sinne der Erfindung wird ein künstliches neuronales Netz verwendet, um die Präsenz und/oder die Position und/oder die Orientierung des Substrates zu ermitteln auf Basis von mindestens einem Bild, welches einen Ort in oder an der Maschine oder in der Umgebung der Maschine darstellt, an welchen sich ein Substrat bei einem Betrieb der Maschine der Halbleiterindustrie befinden kann und/oder welches bearbeitet werden soll.

Unter dem Begriff "Bild" wird im Sinne der Erfindung auch ein digitalisiertes Bild oder eine digitalisierte Darstellung eines analogen Bildes oder einer analogen Repräsentanz verstanden. Das Bild kann vorzugsweise einen Ort oder Bereich in oder an der Maschine der Halbleiterindustrie oder in der Umgebung der Maschine der Halbleiterindustrie abbilden oder darstellen, an dem sich ein Substrat bei einem bestimmungsgemäßen Betrieb der Maschine der Halbleiterindustrie befinden kann. Vorzugsweise handelt es sich hierbei um Orte, an denen das Vorhandensein eines Substrates erwartbar ist.

In anderen Worten, das analoge Bild kann einen Ort abbilden, an welchem sich bei einem fehlerfreien Betrieb der Maschine ein Substrat befinden sollte oder könnte. Das analoge Bild kann also ein Substrat, aber auch einen Ort oder Objekt ohne Substrat darstellen.

Der Ort kann typischerweise etwa ein Aufnahme- oder Ablageort bzw. eine Ablage für Substrate, ein Speicher für Substrate, etwa eine Kassette für die Aufnahme und Speicherung von Wafern. Es kann aber auch ein Ort im Umfeld der Maschine, etwa ein Bodenbereich, sein, welcher während des Transportes des Substrates überquert werden kann. Hier kann es beispielsweise vorkommen, dass sich ein nicht ordnungsgemäßes gehaltertes Substrat während des Transportes löst und auf den Boden auftrifft. Das Bild kann also ein Substrat an oder in einem Aufnahme- oder Ablageort zeigen, welches ordnungsgemäß und fehlerfrei abgelegt ist. Genauso kann es aber auch ein nicht fehlerfrei abgelegtes Substrat in einer sogenannten Fehllage zeigen, also ein nicht fehlerfrei aufgelegtes Substrat, oder auch einen leeren Aufnahmeort, wenn etwa das Substrat an einem anderen Ort abgelegt wurde.

Das Bild kann dabei neben einem Einzelbild auch ein oder mehrere Einzelbilder, beispielsweise aus Videos, oder Videosequenzen, umfassen.

Das zumindest eine Bild kann dabei durch eine Aufnahmeeinheit aufgenommen und in digitalisierter Form dem künstlichen neuronalen Netz zur Verfügung gestellt werden, was bedeutet, dass das Bild quasi "online" im Betrieb des Handlingsystems erzeugt wird. Es kann aber auch quasi "offline" aus einer Datenbank dem künstlichen neuronalen Netz zur Verfügung gestellt werden.

Das künstliche neuronale Netz kann dieses Bild in digitalisierter Darstellung erfassen und analysieren, also für eine Detektion und Klassifikation verwenden, um einen Informationsdatensatz und/oder einen Steuerbefehl zu erzeugen. Selbstverständlich ist es nicht nur möglich, das Bild als Ganzes zu analysieren, sondern auch nur einen Ausschnitt des Bildes.

Unter dem Begriff künstliches neuronales Netz werden im Sinne der Erfindung eine oder mehrere Schichten neuronaler Layer verstanden, und/oder eine oder mehrere Schichten "Convolutional-Layer", auch "Convolution Layer" genannt, mit ihren Verbindungen und/oder Gewichtungen und/oder weiteren Layern und/oder dem Netzwerk zugeordneten Bestandteilen wie beispielsweise Filtern, Aktivierungen, Gewichtungen, "Poolings" oder Rückkopplungen, welche in der Lage sind, Eingangsdaten aufzunehmen, und im Zusammenspiel mit gelernten Daten, Ausgangsdaten daraus zu generieren. Ein "Layer" bezeichnet hierbei eine Hierarchiebene.

Hierzu kann ein Modell eines künstlichen neuronalen Netzes erstellt werden, welches dann in einer Trainingsphase trainiert werden kann. Durch das Training können Verbindungen zwischen künstlichen Neuronen und/oder den Layern gewichtet werden, oder es können weitere Parameter ermittelt werden, welche die Erzeugung des Informationsdatensatzes durch das Netz steuern. Auf diese Weise kann ein trainiertes künstliches neuronales Netz zur Verfügung gestellt werden. Das künstliche neuronale Netz kann auch Verzweigungen aufweisen, oft auch als sogenannte "skip-connections" bezeichnet, was beispielsweise bei komplexeren Aufgabenstellungen Anwendung finden kann.

Ein für die Erfindung geeignetes künstliches neuronales Netz ist dazu ausgebildet, dass es beispielsweise Objekte in Bildern erkennen kann aus einem Bild, welches ein Objekt abbildet, und darauf trainiert oder angelernt wurde, ein solches Objekt zu erkennen. Ferner kann ein derartiges künstliches neuronales Netz einen Informationsdatensatz mit zumindest einer Information darüber generieren, dass ein solches Objekt im Bild abgebildet ist.

In weiteren Ausführungsformen können beispielsweise auch Positionen von Objekten zumindest ungefähr erkannt werden.

Solche künstlichen neuronalen Netze oder Netzwerke sind für verschiedene Aufgabenstellung in verschiedenen Konfigurationen bekannt, beispielsweise, je nach Konfiguration, als CNN-Netzwerk (CNN = "Convolutional" Neuronales Netzwerk), oder KNN-Netzwerk (KNN = "Künstliches Neuronales Netzwerk"), FCN-Netzwerk (FCN = "Fully Convolutional" Netzwerk), RNN-Netzwerk (RNN = "Recurrent" Neuronales Netzwerk) und andere.

Solche künstlichen neuronalen Netzwerke können in ihrer Konfiguration oder im Aufbau an verschiedene Aufgabenstellungen angepasst werden, und werden typischerweise vor dem Einsatz trainiert oder angelernt, können aber auch ergänzend oder alternativ bereits existierende Lerndaten oder vorgelernten Lerndaten übernehmen. Es gibt verschiedene Implementierungsmöglichkeiten solcher Netzwerke, wie beispielsweise "Tensor Flow" oder "Keras".

Das künstliche neuronale Netz kann mindestens ein Modell ausbilden, welches mindestens eine Faltungsebene (Convolutional Layer) und/oder mindestens eine Neuronenebene (Neuronal Layer) umfasst. Dabei kann es weiterhin vorzugsweise zumindest einen der folgenden zusätzlichen Bestandteile umfassen: einen Aktivierungs-Layer, einen Pooling-Layer, einen Flatten-Layer, einen Drop-Layer. Von Vorteil umfasst das künstliche neuronale Netz Daten zur Gewichtung von mindestens einem, bevorzugt mehreren und besonders bevorzugt allen gewichtbaren Bestandteilen des Modelles. Diese Gewichtung kann dabei besonders einfach durch einen Trainingsvorgang bestimmt werden.

Ferner kann das künstliche neuronale Netz zumindest eine der Methoden der Regression, "Machine-Learning" oder "Deep-Learning" verwenden.

Der Lernvorgang solch künstlicher neuronaler Netze wird oft auch als selbstadaptiver Algorithmus oder als "Maschine Learning" verstanden. Wenn eine Reihe von Hierarchieebenen bzw. "Layern" verwendet wird, so wird dies auch als "Deep-Learning" bezeichnet, wobei die dafür erforderliche Anzahl der "Layer" nicht genau definiert ist.

Es versteht sich, dass im Rahmen der Erfindung für das Verfahren zur Bearbeitung von Substraten, insbesondere von Wafern, Masken oder Flat Panel Displays, mit einer Maschine der Halbleiterindustrie, vorzugsweise ein trainiertes oder angelerntes künstliches neuronales Netz verwendet wird.

Im Sinne der Erfindung kann zumindest eine digitalisierte Darstellung eines analogen Bildes durch das künstliche neuronale Netz erfasst und analysiert werden. Damit kann dann durch das künstliche neuronale Netz ein Informationsdatensatz erzeugt werden, umfassend eine Information über die ermittelte Präsenz und/oder Position und/oder Orientierung und/oder den Typ des Substrates. Dieser Informationsdatensatz kann dazu genutzt werden, die Maschine der Halbleiterindustrie direkt zu steuern, oder er kann von der Steuerung der Maschine verwendet werden. Der Informationsdatensatz kann auch an ein übergeordnetes Steuerungssystem weitergegeben werden.

Der Informationsdatensatz kann zum Beispiel einen Steuerbefehl generieren oder ein Steuerbefehl kann durch die Auswertung des Informationsdatensatzes erzeugt werden, welcher eine Anweisung umfasst zum Bewegen eines Anlagenteils der Maschine der Halbleiterindustrie, beispielsweise zum Bewegen eines Roboters und/oder des beweglichen Elements des Roboters, bevorzugt des Roboterarms oder des Endeffektors des Roboters, oder einer Verfahreinheit.

So kann zum Beispiel der Endeffektor zu einem Slot einer Kassette für Wafer bewegt werden. Der Steuerbefehl kann auch eine Anweisung zum Greifen des Substrates, zum Transportieren des Substrates zu einem vorgesehenen Ablageort und/oder Ablegen des Substrates an dem vorgesehenen Ablageort umfassen.

Der Informationsdatensatz kann auch an einen Bediener weitergegeben werden, etwa drahtlos an eine Anzeigeeinheit oder ein Display, so dass der Bediener dann aus dieser Information Rückschlüsse für sein Handeln zur Bedienung der Maschine ziehen kann. Der Bediener kann ferner diese Information an Steuerungen oder andere Bediener weitergeben, oder der Informationsdatensatz kann für spätere oder weitere Auswertung gespeichert werden.

Der durch das künstliche neuronale Netz erzeugte Informationsdatensatz umfasst zumindest eine Information, aus welcher die Präsenz des Substrates in einem Slot, oder auf einer Auflage, oder auf einem Roboter, oder auf einem Endeffektor, oder auf einer Bearbeitungsstation in der Maschine, oder an einem anderen Ort, wo sich die Maske in der Maschine der Halbleiterindustrie befinden kann, ermittelt werden kann oder ableitbar ist.

Der Informationsdatensatz kann auch zumindest eine Information umfassen, aus welcher die räumliche Orientierung des Substrates in Bezug auf die zu einem Roboter der Maschine gerichtete Seite eines Slots, oder in Bezug zu einer Auflage, oder in Bezug zu einer Bearbeitungsstation, oder in Bezug zu einem anderen Teil der Maschine, ermittelt werden kann oder ableitbar ist.

Ferner kann der Informationsdatensatz auch zumindest eine Information umfassen, aus welcher die räumliche Lage des Substrates zu einem Slot, oder zu einer Auflage, oder zu einem Roboter, oder zu einem Endeffektor, oder zu einem anderen Ort, wo sich das Substrat in der Maschine der Halbleiterindustrie befinden kann, ermittelt werden kann oder ableitbar ist.

Ferner kann der Informationsdatensatz auch zumindest eine Information umfassen, aus welcher der Typ des Substrates ermittelt werden kann oder ableitbar ist. Hintergrund hierzu ist, dass in den Maschinen der Halbleiterindustrie auch Substrate verarbeitet werden können, die weitere Aufbauten tragen. Solche Aufbauten können zum Beispiel Teile eines Messsystems sein, welches in die Maschine eingebracht wird, um die Maschinen zu kalibrieren. Die Aufbauten können beispielsweise eine Kalibriereinrichtung für die Maschine enthalten, oder ein Messmittel oder andere Bauteile umfassen. Diese Aufbauten können verschiedene Formen haben, und, ähnlich einem "Pellicle" auf einer Maske, mit dem Substrat in verschiedenen Lagen, Orientierungen und Lagen in der Maschine vorliegen. Für das Bearbeiten der Substrate ist es demzufolge ebenso erforderlich, auch diese Aufbauten und damit den Typ des Substrates zu erkennen, sowie deren Lage, Orientierung oder Position auf dem Substrat. Der Informationsdatensatz kann demzufolge auch eine Information über den Typ des Aufbaus umfassen.

Weiterhin können Substrate auch auf Substrathaltern montiert sein, und mit dem Substrathaltern beispielsweise in einer Kassette oder auf einer Auflage liegen. Dabei können die Substrate wiederum auf den Substrathaltern aufliegen, auf diesen geklemmt sein, oder über Verbindungstechnologien wie beispielsweise Kleben fest mit dem Substrathalter verbunden sein. Dabei können die Substrathalter jeweils mit oder ohne Substrat ebenso in verschiedenen Lagen, Orientierungen und Lagen in der Maschine vorliegen, und müssen erkannt werden. Die Substrate können dabei auch zusammen mit dem Substrathalter in der Maschine bewegt und/oder bearbeitet werden.

Demzufolge kann es in einer Ausführungsform der Erfindung vorgesehen sein, durch das künstliche neuronale Netz zu bestimmen beziehungsweise zu klassifizieren, ob ein Substrat ein Typ
- ohne Aufbau und ohne Substrathalter ist,
- mit Aufbau und ohne Substrathalter ist,
- ohne Aufbau und mit Substrathalter ist,
- mit Aufbau und mit Substrathalter ist.

In Fortführung dieser Aufstellung können weitere Dimensionen in die Klassifikation mit einbezogen werden wie das Vorhandensein eines Pellicles auf einer Maske, und/oder auch verschiedene Ausführungsformen von Substrathaltern oder Aufbauten, so dass sich eine große Vielzahl von möglichen Konfigurationen von Substrattypen ergeben kann.

Eine besonders in der EUV-Technologie der Halbleiterindustrie, also im Bereich der Fotolithographie verwendete Ausführungsform eines Substrathalters für Masken besteht aus einer unteren und oberen Schale ("Dual-Pod"), in welchem die Maske von allen Seiten umschlossen ist, wobei der Behälter wiederum beispielsweise in einer Kassette oder auf einer Auflage liegen kann.

Erfindungsgemäß ist es mit den dargestellten Verfahren des künstlichen neuronalen Netzes auch möglich, die Präsenz und/oder die Lage und/oder die Orientierung und/oder die Position eines Substrattyps zu bestimmen, also etwa das Vorhandensein eines bestimmten Typs eines Substrates. Weiterhin ist dabei auch eine Klassifikation des Typs des Substrates zu möglich.

Dazu wird das künstliche neuronale Netzwerk entsprechend konfiguriert, dass es die erforderlichen Typen erkennen kann, d.h. es müssen weitere Ausgangsneuronen für die hinzugekommenen Klassen hinzugefügt werden. So kann beispielsweise ein Modell, welches die zwei Klassen "freier Slot" und "belegter Slot" für Wafer erkennt, beispielsweise die Erkennung eines Wafers mit Substrathalter hinzugefügt werden, indem ein Ausgangneuron hinzugefügt wird. Die dann insgesamt drei Ausgangneuronen repräsentieren drei Klassen "freier Slot", "Slot mit Wafer ohne Substrathalter" und "Slot mit Wafer mit Substrathalter".

Ergänzend können Änderungen in den Layern vorgenommen werden, um das künstliche neuronale Netz auf die dann komplexere Aufgabenstellung auszurichten. In dem Beispiel wird ersichtlich, dass durch das künstliche neuronale Netz ein Informationsdatensatz erzeugt werden kann, aus welcher sowohl die Präsenz, als auch der Typ eines Wafers (mit oder ohne Substrathalter), abgeleitet werden kann.

Der Lernvorgang wie weiter unten erläutert kann zum Beispiel erfolgen mit den zusätzlichen Bildern und Klassen des Wafers mit oder ohne Substrathalter, und in der Anwendung generiert das künstliche neuronale Netz dann Datensätze, aus welchen die beschriebenen drei Klassen ableitbar sind. Damit ist ableitbar, ob der Slot frei ist oder belegt (Präsenz eines Wafers), und bei belegtem Slot, ob der Wafer ein Wafer mit oder ohne Substrathalter ist.

In ähnlicher Weise kann der Informationsdatensatz auch zumindest eine Information umfassen, aus welcher die Präsenz eines Pellicles auf einem Substrat, insbesondere auf einer Maske, und/oder die Seite, also die Oberseite oder die Unterseite eines abgelegten Substrates, insbesondere einer Maske, auf der sich ein Pellicle befindet, ermittelt werden kann oder ableitbar ist.

Ferner kann der Informationsdatensatz auch zumindest eine Information umfassen, aus welcher die Orientierung eines Pellicles in Bezug zu einer Referenzachse einer Auflage, einer Kassette, eines Roboters, eines Endeffektors, ermittelt werden kann oder ableitbar ist.

Zusammenfassend kann der Informationsdatensatz zumindest eine Information umfassen, aus welcher die Präsenz und/oder die Position und/oder die Orientierung und/oder den Typ eines Substrates, ermittelt werden kann oder ableitbar ist

Ein wichtiger Aspekt der Erfindung ist darin zu sehen, für das Bearbeiten der Substrate eine Information dahingehend zu erhalten, ob das Substrat bearbeitet, beispielsweise auch transportiert werden kann, oder nicht, etwa aufgrund einer Fehllage. Die Information kann damit betreffend mögliche Fehllagen beispielsweise eine Aussage darüber liefern, ob die Fehllage ein über mehrere Etagen einer Auflage liegendes Substrat betrifft ("cross-slotted"), also etwa ob das Substrat auf den vorgesehenen Auflagepunkten dieser Auflage liegt, und/oder ob die Fehllage mindestens zwei direkt übereinanderliegende Substrate betrifft ("doubleslotted") an einem Auflagepunkt, also ob an den Auflagepunkten oder der Auflage mehr als ein Substrat liegt, insbesondere, wenn nur ein Substrat an diesem Auflagepunkt vorgesehen ist.

Ferner kann die Information eine Aussage liefern, ob die Fehllage eine Abweichung von einer vorgegebenen Soll-Lage eines Substrates betrifft, und/oder ob die Fehllage ein nicht auf allen vorgesehenen Auflagepunkten einer Auflage korrekt aufliegendes Substrat betrifft.

Der von dem künstlichen neuronalen Netz erzeugte Informationsdatensatz liefert damit eine Information, welche die weitere Bearbeitung des Substrates beeinflussen und bestimmen kann. Das Substrat kann sich dabei in Kassetten und/oder auf Auflagen und/oder auf einem Endeffektor und/oder auf einem Chuck und/oder auf einer Bearbeitungsstation der Maschine und/oder auf einer Verfahreinheit befinden.

In einem weiteren Aspekt betrifft die Erfindung demnach ein Verfahren zur Bearbeitung von Substraten, insbesondere von Wafern, Masken oder Flat Panel Displays, mit einer Maschine der Halbleiterindustrie, wobei zum Bestimmen der Präsenz und/oder der Position und/oder der Orientierung und/oder den Typ eines Substrates vorzugsweise ein künstliches neuronales Netz verwendet wird, um die Präsenz und/oder die Position und/oder die Orientierung des Substrates zu ermitteln auf Basis von mindestens einem Bild, welches einen Ort in oder an der Maschine der Halbleiterindustrie oder in der Umgebung der Maschine der Halbleiterindustrie darstellt, an dem sich ein Substrat bei einem Betrieb der Maschine der Halbleiterindustrie befinden kann, wobei das mindestens eine Bild vorzugsweise von mindestens einer Aufnahmeeinheit aufgenommen wird, und wobei aus dem erzeugten Informationsdatensatz ein Steuerbefehl zum Steuern der Maschine der Halbleiterindustrie erzeugt oder abgeleitet wird. Mit dem abgeleiteten Steuerbefehl kann die Maschine der Halbleiterindustrie direkt gesteuert werden, oder der abgeleitete Steuerbefehl kann von der Steuerung der Maschine verwendet werden oder an ein übergeordnetes Steuerungssystem weitergegeben werden, oder der abgeleitete Steuerbefehl kann von der übergeordneten Maschine generiert werden.

Das Bild kann dabei von einer entsprechenden Aufnahmeeinheit erfasst und in eine digitale Darstellung umgewandelt werden, oder auch von einer Datenbank zugeführt werden.

Zur Erzeugung des Bildes kann zumindest eine Aufnahmeeinheit vorgesehen sein, welche in die Maschine integriert und/oder an die Maschine angebaut sein kann. Sie kann auch im Umfeld der Maschine angeordnet sein. Die Aufnahmeeinheit kann dabei dauerhaft fest oder auch nur zeitweise fest intergiert oder angebaut sein, etwa zum Trainieren des künstlichen neuronalen Netzes, und kann dann nach Abschluss des Anlernens wieder entfernt werden.

In einer Ausführungsform der Erfindung ist die mindestens eine Aufnahmeeinheit in Bezug auf die Maschine ortsunveränderlich installiert. Dies ermöglicht es, unabhängig von dem Betriebszustand der Maschine immer eine gleiche Perspektive bzw. Blickrichtung während der Aufnahme der Bilder zu erhalten, so dass selbst geringste Änderungen bzw. Abweichungen von einer Soll-Lage des Substrates sicher erkannt werden können.

Es ist auch möglich, dass sich die mindestens eine Aufnahmeeinheit an beweglichen Elementen der Maschine befindet, beispielsweise an einem Roboterarm oder einem beweglichen Element, etwa an einem Endeffektor eines Roboters, oder an einer Verfahreinheit. Dies ermöglicht es, Bilder von dem Substrat oder von dem vorgesehenen Ort während des Betriebs aus unterschiedlichen Blickrichtungen aufzunehmen, was von Vorteil sein kann, wenn etwa bei Ansichten aus bestimmten Blickrichtungen Teile des Bildes verdeckt sind, und damit das aufgenommene Bild unvollständig ist.

Daher ist es in einer besonders bevorzugten Ausführungsform der Erfindung vorgesehen, im Fall von unklaren Aussagen oder nicht eindeutigen Zuordnungen durch das künstliche neuronale Netz zumindest ein weiteres Bild des Ortes zu erzeugen und durch das künstliche neuronale Netz zu erfassen, wobei sich von Vorteil dieses zweite, weitere Bild von dem ersten in zumindest einem Aspekt, beispielsweise der Blickrichtung, unterscheidet.

Im Fall einer teilweisen Verdeckung kann auf diese Weise beispielsweise ein weiteres Bild desselben Ortes aus einem anderen Blickwinkel aufgenommen werden, auf welchen diese Verdeckung nicht auftritt. Diese zweite Aufnahme aus einem anderen Blickwinkel kann dabei in einer bevorzugten Ausführungsform der Erfindung durch das künstliche neuronale Netz selbst veranlasst werden, in dem etwa ein entsprechender Steuerbefehl an die Steuerung der Maschine ausgegeben wird.

Weiterhin kann, wenn zumindest eine Aufnahmeeinheit verfahrbar an einem Roboter oder einer Verfahreinheit angebracht ist, diese Aufnahmeeinheit verfahren und auch auf verschiedene Orte gerichtet werden, wodurch die Anzahl der notwendigen Aufnahmeeinheit in einer Maschine reduziert werden kann.

Die Aufnahmeeinheit kann einen optischen Sensor, einen Ultraschall-Sensor, einen Abstands-Sensor, einen Reflex-Sensor, ein Radar-Sensor, eine bildgebende Kamera oder Video-Kamera, oder eine Infrarotkamera umfassen.

Die Infrarotkamera ermöglicht es zum Beispiel, zusätzlich Informationen der Wärmestrahlung der Objekte im Bildfeld, also des Ortes oder des Substrates, zur Verfügung zu stellen. Dies kann nützlich sein, wenn beispielsweise das Substrat für bestimmte Bearbeitungsprozessen einer genau vorgegebenen Temperatur ausgesetzt sein soll, und das Substrat nur bewegt werden soll, wenn das Substrat selbst oder die Umgebung eine bestimmte Temperatur aufweist.

Der Radar-Sensor ermöglicht es, Abstandswerte von Objekten beziehungsweise von einzelnen Punkten von Objekten zum Sensor in dem durch den Sensor erfassten zweidimensionalen Bereich zu erzeugen, welche zusammengesetzt mit der dritten Abstands-Dimension ein dreidimensionales Profil des erfassten Bereiches darstellen können, welches anstelle des optischen Bildes für das Trainieren oder Anlernen, oder auch für das Anwenden des künstlichen neuronalen Netzes verwendet wird.

Es ist in einer bevorzugten Ausführungsform der Erfindung auch vorgesehen, durch das künstliche neuronale Netz mehr als ein Bild zu erfassen, insbesondere zumindest zwei Bilder des gleichen Ortes, welche von unterschiedlichen Aufnahmeeinheiten und/oder unterschiedlich angeordneten Aufnahmeeinheiten erzeugt wurden. Die Informationen dieser Bilder können auf besonders vorteilhafte Weise durch das künstliche neuronale Netz analysiert und miteinander kombiniert werden, um die Zuordnung zu hinterlegten Klassen und damit die Qualität des Informationsdatensatzes erheblich zu verbessern. Insbesondere kann hierdurch die Entscheidungsgrundlage für das künstliche neuronale Netz verbessert werden.

Hierdurch können deutlich genauere Informationen über ein Substrat erhalten werden, und die Maschine kann deutlich besser gesteuert werden.

In einem ersten Aspekt können dabei zumindest zwei Bilder durch das künstliche neuronale Netz erfasst werden, welche sich durch die Position der Aufnahmeeinheit und damit in der Blickrichtung des aufgenommenen Bildes unterscheiden. Hiermit ist es auch möglich, beispielsweise in einer Aufnahme verdeckte Bereiche darzustellen.

Hierzu kann es zum Beispiel vorteilhaft sein, eine erste Aufnahmeeinheit, beispielsweise eine Kamera, ortsfest an der Maschine zu installieren, welche ein Bild von dem Substrat oder Ort aufnimmt, und eine weitere zweite Aufnahmeeinheit, beispielsweise eine Kamera oder eine Video-Kamera, welche sich an einem beweglichen Element der Maschine befindet, etwa an dem Endeffektor oder der Verfahreinheit. Im Betrieb kann dann ein erstes Bild mit der ersten Kamera erzeugt und dem künstlichen neuronalen Netz zugeführt werden. Wenn die Auswertung durch das künstliche neuronale Netz dann keine zuverlässige Information zum Beispiel darüber liefern kann, ob das Substrat auf sämtlichen Auflagepunkten einer Auflage vollständig und korrekt aufliegt, kann dann die zweite Kamera oder Video-Kamera während einer weiteren Annäherung des Endeffektors an das Substrat oder den Ort zugeschaltet werden, und weitere Bilder oder Video-Sequenzen können erzeugt und dem künstlichen neuronalen Netz zugeführt werden. Sofern dann mehrere Bilder von dem zu untersuchenden Ort vorliegen, ermöglicht dies dem künstlichen neuronalen Netz eine bessere Datenbasis und kann dazu beitragen, die Zuverlässigkeit in der Analyse deutlich zu erhöhen.

Mit diesem Verfahren können besonders günstig die Auswirkungen von Fehllagen minimiert werden, da deutlich genauer erkannt werden kann, ob beispielsweise ein Substrat noch bearbeitet werden kann oder nicht. Dies erhöht die Effizienz der Maschine der Halbleiterindustrie.

Neben einer im Vergleich zur Erzeugung des ersten Bildes unterschiedlich angeordneten Aufnahmeeinheit zur Erzeugung des zumindest einen weiteren Bildes kann das zweite Bild auch mit einer Aufnahmeeinheit erzeugt werden, welche andere Informationen beiträgt. So kann beispielsweise eine im sichtbaren Wellenlängenbereich arbeitende Kamera mit einer Infrarotkamera oder eine Infrarotkamera mit einem Radar-Sensor kombiniert werden.

In einer weiteren ebenfalls bevorzugten Ausführungsform ist ergänzend oder alternativ vorgesehen, die Zuverlässigkeit der Bestimmung durch das künstliche neuronale Netz und damit die Qualität des Informationsdatensatzes nochmals zu verbessern, wenn etwa durch das künstliche neuronale Netz nicht zweifelsfrei eine Aussage über die Präsenz eines Substrates erhalten werden kann.

So kann zum Beispiel ein leicht schräg aufgelegtes Substrat, welches damit nicht vollkommen fehlerfrei aufliegt, unter bestimmten Umständen dennoch bearbeitet oder prozessiert werden, beispielsweise durch Vorgeben bestimmter Steuerbefehle an die Steuereinheit der Maschine, um auch das leicht schräg aufgelegt Substrat noch greifen zu können.

Erfindungsgemäß ist dazu in einer Ausführungsform vorgesehen, nach Analyse durch das künstliche neuronale Netz in einem weiteren zweiten Schritt mindestens ein durch das künstliche neuronale Netz ermittelte Merkmal mittels eines weiteren Verfahrens der Bilderkennung zu analysieren. Hierzu kann ein klassisches Verfahren zur Bilderkennung, insbesondere ein regelbasiertes Verfahren, verwendet werden. Dies kann beispielsweise ein Verfahren zur Kantenerkennung mittels einer (klassischen) Bildverarbeitung sein. Hierzu kann das ursprünglich erfasste Bild verwendet werden. Weiterhin können dafür ergänzend auch Sensoren zum Einsatz kommen, welche nicht auf einer Bildaufnahme basieren.

Mit dem hier skizzierten zweistufigen Ansatz kann die Zuverlässigkeit der Information des künstlichen neuronalen Netzes geprüft und/oder durch Verbindung des ersten mit dem zweiten Schritt verbessert werden.

Es ist dem Fachmann ersichtlich, dass die vorstehend genannten Verfahren auch miteinander kombiniert werden können. Dies führt zu einem großen Vorteil der Erfindung, der darin zu sehen ist, dass nicht nur vollständig fehlerfrei abgelegte Substrate prozessiert werden können, sondern auch noch Substrate, welche anhand von entsprechend klassifizierten Bilder durch das künstliche neuronale Netz als noch bearbeitbar angesehen werden.

Vorgesehen ist ferner eine Beleuchtungseinrichtung, welche dazu ausgebildet ist, elektromagnetische Strahlung in Richtung auf das Substrat oder den entsprechenden Ort im Bildfeld der Aufnahmeeinheit in oder an der Maschine oder der Umgebung zu emittieren. In einer vorteilhaften Ausführungsform der Erfindung ist die Beleuchtungseinrichtung gekoppelt mit der Aufnahmeeinheit, so dass die Beleuchtungseinrichtung vorzugsweise dann zugeschaltet wird und elektromagnetische Strahlung emittiert, wenn mit der Aufnahmeeinheit ein Bild erfasst wird.

Bei Verwendung einer Kamera, welche im sichtbaren Wellenlängenbereich der elektromagnetischen Strahlung sensitiv ist, bietet es sich an, wenn die Beleuchtungseinrichtung ebenfalls elektromagnetische Strahlung zumindest im sichtbaren Wellenlängenbereich, also im Wellenlängenbereich zwischen 380 und 780 nm, emittiert. Von Vorteil ist daher die Beleuchtungseinrichtung derart ausgebildet, dass sie elektromagnetische Strahlung zumindest in demjenigen Wellenlängenbereich emittiert, in welchem die Aufnahmeeinheit sensitiv ist.

In diesem Zusammenhang können auch Bilder erfasst und dem künstlichen neuronalen Netz zugeführt werden, welche bei einer unterschiedlichen Beleuchtung aufgenommen wurden.

Die Beleuchtungseinrichtung kann dabei in die Maschine dauerhaft fest oder zeitweise fest integriert und/oder an der Maschine angebaut sein. Es kann sich anbieten, die Beleuchtungseinrichtung in Bezug auf die Maschine ortsunveränderlich zu installieren, um jeweils gleiche Beleuchtungssituationen für das Erfassen eines Bildes zu schaffen.

Es kann sich aber auch als günstig erweisen, die Beleuchtungseinrichtung an beweglichen Elementen der Maschine anzuordnen, bevorzugt an einem Roboterarm oder an einem Endeffektor eines Roboters oder an einer Verfahreinheit. Besonders vorteilhaft kann diese Anordnung sein, wenn auch die Aufnahmeeinheit zusammen mit der Beleuchtungseinheit angeordnet ist, so dass während der Bildaufnahme jeweils aus der gleichen Richtung beleuchtet wird, aus der auch die Bildaufnahme erfolgt.

Aufnahmeeinheit und Beleuchtungseinheit können beispielsweise in einer kompakten Bauform gemeinsam in einem Gehäuse vorgesehen sein.

Das künstliche neuronale Netz kann in einer Verarbeitungseinheit als Komponente einer Rechnerarchitektur aufgenommen oder integriert sein, wobei die Rechnerarchitektur ferner eine Rechner-Hardware und ein Betriebssystem des Rechners als weitere wesentliche Komponenten neben anderen Komponenten oder Bauteilen umfassen kann.

Von Vorteil ist die Rechnerarchitektur derart ausgebildet, dass das Erzeugen des Informationsdatensatzes durch das künstliche neuronale Netz nahezu in Echtzeit oder sogar in Echtzeit nach DIN ISO/IEC 2382 erfolgt. Hiermit ist die Zeitspanne zwischen Aufnahme des Bildes und Ausgabe des Informationsdatensatzes durch das künstliche neuronale Netz zu verstehen. Es ist auch denkbar, die Bilder aufzuzeichnen, und den Informationsdatensatz mit zeitlichem Versatz zu erzeugen, wenn das in der konkreten Anwendung möglich ist.

Die Rechnerarchitektur kann zentral oder dezentral organisiert sein. Dies bedeutet, dass zumindest die drei vorstehend genannten Komponenten Verarbeitungseinheit, Rechner-Hardware und Betriebssystem an einer Stelle zusammengefasst sein können, oder einzeln verteilt an verschiedenen Stellen oder auch an verschiedenen Standorten angeordnet sein können. Die Kommunikation zwischen den einzelnen Komponenten kann dabei drahtgebunden oder auch drahtlos über geeignete Funk-Verfahren, zum Beispiel W-LAN oder Bluetooth, erfolgen. Auch die Aufnahmeeinheit kann die Bilder drahtgebunden oder drahtlos übertragen.

So können gemäß einer zentral organisierten Ausführungsform der Erfindung diese Komponenten in einem System-Controller der Maschine der Halbleiterindustrie integriert sein, beispielsweise in einen Roboter oder in einen Endeffektor eines Roboters, oder in einem Roboter-Controller. Die Rechnerarchitektur kann auch in einer der Maschine übergeordneten Steuerung integriert sein.

In einer bevorzugten Ausführungsform kann diese Rechnerarchitektur in einer der Maschine nicht zugeordneten Steuerung integriert sein, beispielsweise in einer Cloud oder in einem anderen Rechner an einem beliebigen weltweiten Standort. Dies ermöglicht es beispielsweise, an einer zentralen Stelle sämtliche für das künstliche neuronale Netz erforderlichen Daten zu bündeln und zentral zur Verfügung zu stellen.

Gemäß einer dezentral organisierten Ausführungsform der Rechnerarchitektur können einzelne der oben genannten Komponenten, also Verarbeitungseinheit, Rechner-Hardware oder Betriebssystem, an verschiedenen Stellen angeordnet sein. Diese können die vorstehend genannten Stellen sein, also beispielsweise der System-Controller der Maschine oder der Endeffektor.

So kann es günstig sein, die Verarbeitungseinheit und/oder die das Betriebssystem über mehr als einen dieser Stellen wie vorstehend bezeichnet verteilt ablaufen zu lassen. Dies bietet sich an, wenn etwa sehr große Datenbestände mit Bildern vorhanden sind oder erzeugt wurden, welche zentral gespeichert und verwaltet werden sollen. Die Verarbeitungseinheit mit den Datenbeständen kann dann beispielsweise in einer zentralen Cloud vorgehalten werden, und die Rechner-Hardware und/oder das Betriebssystem kann dezentral an oder in der Maschine der Halbleiterindustrie vorgehalten werden. Es ist für den Fachmann ersichtlich, dass auch andere Kombinationen möglich und günstig sein können.

So kann etwa auch das Trainieren des künstlichen neuronalen Netzes auf einer anderen, weiteren Rechnerarchitektur durchgeführt wird als die Anwendung des künstlichen neuronalen Netzes.

In einem weiteren Aspekt betrifft die Erfindung ein Verfahren zum Bereitstellen eines angelernten oder trainierten künstlichen neuronalen Netzes zur Verwendung in einem Verfahren zur Bearbeitung von Substraten, insbesondere von Wafern, Masken oder Flat Panel Displays, mit einer Maschine der Halbleiterindustrie, wobei zum Bestimmen der Präsenz und/oder der Position und/oder der Orientierung eines Substrates ein künstliches neuronales Netz verwendet wird.

Das Verfahren zum Bereitstellen eines angelernten oder trainierten künstlichen neuronalen Netzes kann dabei die nachfolgenden Schritte umfassen:
- Bereitstellen einer Verarbeitungseinheit, welche zumindest ein künstliches neuronales Netz, aufweist oder umfasst,
- Trainieren des künstlichen neuronalen Netzes durch Erfassen und Bereitstellen von zumindest einem Bild, bevorzugt, einer Vielzahl von wenigstens 20 Bildern, wenigstens 100, besonders bevorzugt wenigstens 1.000 Bildern.

Es kann bereits mit einem oder wenigen Bildern möglich sein, das künstliche neuronale Netz zu trainieren. So kann beispielsweise ein Bild ein fehlerfrei auf einem Slot abgelegtes Substrat zeigen, welches dann für die weitere Analyse durch das künstliche neuronale Netz herangezogen wird. Nachteilig kann es dabei sein, dass nur solche Bilder von Substraten dann als fehlerfrei erkannt und entsprechend bewertet werden können, wenn sie diesem einen Bild entsprechen. Bereits leichte Abweichungen von dieser Position könnten dann durch das künstliche neuronale Netz nicht mehr optimal erkannt werden.

Von daher wird es sich in den allermeisten Fällen anbieten, mehrere Bilder, bevorzugt eine Vielzahl von Bildern, bevorzugt wenigstens 20 Bildern, wenigstens 100, besonders bevorzugt wenigstens 1.000 Bildern oder noch mehr dem künstlichen neuronalen Netz zur Verfügung zu stellen.

Wie weiter oben ausgeführt, kann das digitalisierte Bild dabei vollständig das erfasste analoge Bild umfassen, oder auch nur einen Bildausschnitt oder auch mehrere Bildausschnitte. Dies kann sich beispielsweise anbieten, wenn die ordnungsgemäße Belegung einer Kassette für Wafer geprüft werden soll. Eine derartige Kassette kann beispielsweise 25 einzelne Ablageorte für Wafer umfassen, wobei dann aus einem analogen Gesamtbild jeweils Einzelbilder bzw. Slot-Bilder für jeden Ablageort generiert werden, im Beispiel also 25 Einzelbilder.

Ein Bildausschnitt bzw. ein Einzelbild kann demnach einen Ablageort darstellen. Die Verarbeitungseinheit kann hierzu von Vorteil entsprechende Module oder Einrichtungen für eine Bildverarbeitung umfassen.

In einer bevorzugten Ausführungsform umfasst das Verfahren zum Bereitstellen eines angelernten oder trainierten künstlichen neuronalen Netzes das Erfassen und/oder Bereitstellen einer Vielzahl von Bildern für das Trainieren, welche sich in der Ausprägung zumindest eines Parameters oder Einflussfaktors unterscheiden. Diese Parameter können sich auf das Substrat oder die Umgebung des Ortes, welcher aufgenommen werden soll, beziehen.

Demnach unterscheiden sich Bilder vorzugsweise in der Ausprägung zumindest eines Parameters voneinander. Hierzu können gehören:
- die Präsenz des Substrates an einem Ort, also das Vorhandensein oder das Fehlen eines Substrates an einem Ort, beispielsweise im Slot einer Kassette oder auf einer Auflage, und an welchem ein Substrat vorhanden sein sollte. Selbstverständlich können diese Bilder auch Orte umfassen, an denen bei fehlerfreiem Betrieb der Maschine kein Substrat vorhanden sein sollte,
- die Lage des Substrates in Bezug auf eine Soll-Lage, also beispielsweise das korrekte Aufliegen des Substrates auf den hierfür vorgesehenen Auflagepunkten,
- die Orientierung des Substrates in Bezug auf eine Referenz in der Maschine
- die Anzahl der Substrate an einem Ort, also beispielsweise die Anzahl der Substrate in einem Slot einer Kassette oder in der Kassette insgesamt,
- die Farbe und/oder das Transmissionsverhalten des Substrates,
- der Typ des Substrates
- die Abmessungen des Substrates
- die Beschaffenheit der Kanten des Substrates
- das Vorhandensein von Erkennungsmarken, also beispielsweise das Vorhandensein von sogenannten "Wafer-Notches" auf oder an dem Substrat,
- die Beschaffenheit der Oberfläche des Substrates, also beispielsweise eine glatt, rauhe oder beschichtet Oberfläche,
- das Vorhandensein eines Pellicle sowie Ort, Lage und Orientierung des Pellicle in Bezug auf das Substrat.

Weitere Parameter können die Umgebung betreffen:
- die Beleuchtungsverhältnisse, also etwa die Lichtstärke und/oder Lichtrichtung,
- die Art, die Farbe und/oder die Beschaffenheit des Hintergrundes,
- die Bildschärfe,
- die Fokussierung,
- die Reflektion anderer Objekte auf das Substrat
- Lichteinstreuung aus der Umgebung.

Die vorstehend genannte Auflistung von Parametern und Einflussgrößen sowie ihre möglichen Ausprägungen ist nicht als abschließend zu betrachten. Sie stellt vielmehr eine Auswahl geeigneter Parameter und Ausprägungen dieser Parameter dar.

In einer Weiterbildung der Erfindung können die Unterschiede in zumindest einem Teil dieser Bilder auch künstlich erzeugt werden, beispielsweise durch sogenannte "Augmentierung". Die hierzu verwendeten Bilder können von der Aufnahmeeinheit stammen, oder es können auch andere Bilder verwendet werden, beispielsweise aus einer Datenbank.

Das künstliche neuronale Netz kann anhand einer Kategorisierung oder Klassifikation der Bilder trainiert werden.

Ziel für das Trainieren des künstlichen neuronalen Netzes ist es typischerweise, eine möglichst große Bandbreite an unterschiedlichen Ausprägungen der Parameter zu erfassen und zu Klassifizieren.

In einer bevorzugten Ausführungsform ist vorgesehen, dass auch während der Anwendung des künstlichen neuronalen Netzes, also während des Verfahrens zur Bearbeitung von Substraten mit der Maschine der Halbleiterindustrie, in der Maschine Bilder erfasst und gespeichert werden, um diese in mindestens einem initialen oder mindestens einem neuen Lernprozess zum weiteren Trainieren und damit zur stetigen Verbesserung des Ergebnisses des künstlichen neuronalen Netzes zu verwenden.

Hierdurch ist es beispielsweise möglich, auch Schwankungen in der Ausprägung von Parametern, welche sich über längere Zeiträume ergeben können, zu erfassen und dem künstlichen neuronalen Netz zur Verfügung zu stellen. So kann es zum Beispiel vorkommen, dass sich die Lichtverhältnisse durch natürliches Licht an einem Aufnahmeort für Substrate im Jahresverlauf ändern. Durch die kontinuierliche Nachführung können derartige Schwankungen oder "schleichende" Veränderungen kompensiert werden.

Auch bei künstlicher Beleuchtung kann es zu solchen "schleichenden" Veränderungen während des Betriebes der Maschine der Halbleiterindustrie kommen, was bei regelbasierenden Bildverarbeitungssystem zu Problemen führen kann. So unterliegen zum Beispiel auch moderne LED Leuchten und Leuchtmittel Alterserscheinungen, beispielsweise Alterung, Degradation, Helligkeitsverlust und/oder Lichtstromrückgang. Der Lichtstrom kann also sich über die Zeit verändern, insbesondere sinken. Dies kann auch unterschiedlich schnell erfolgen, der Rückgang verhält sich dabei nicht linear. Der Lichtstrom sinkt anfangs nur sehr langsam und fällt mit der Zeit immer schneller ab.

Gründe hierfür können in minimalen Verunreinigungen im Halbleiterkristall des LED-Chips liegen, welche zu Materialveränderungen über die Zeit führen können.

Auch hier kommen die Vorteile des erfindungsgemäßen Verfahrens zum Tragen. So kann das künstliche neuronale Netz in einen quasi-kontinuierlichen Zustand "nachgelernt" werden, in dem zu bestimmten, regelmäßigen Zeitabständen, beispielweise einmal wöchentlich oder monatlich, Bilder durch das künstliche neuronale Netz aktuelle Bilder erfasst werden. Diese Bilder können mit bereits vorhandenen und gespeicherten Bildern verglichen werden, so dass das künstliche neuronale Netz in Bezug auf die Veränderungen in Bezug auf die Produktionsumgebung und/oder die Substrate kontinuierlich oder quasi-kontinuierlich trainiert werden kann. Durch das künstliche neuronale Netz können damit auch sehr geringe Veränderungen in der Produktionsumgebung, aber auch in Bezug auf die Substrate, etwa, wenn sich geometrische Abmessungen ändern, kompensiert werden. Dies ist bei regelbasierenden Systemen nicht möglich. Auch eine Augmentierung erscheint hier schwierig, da beispielsweise Alterungsprozesse von Leuchten simuliert werden müssten.

Mit von der Erfindung umfasst ist ferner ein System zur Bearbeitung von Substraten, insbesondere von Wafern, Masken oder Flat Panel Displays, ausgebildet zur Ausführung eines Verfahrens wie vorstehend beschrieben.

Das System kann eine Maschine der Halbleiterindustrie, einen Roboter, ein bewegliches Element, bevorzugt ein Roboterarm und/oder ein Endeffektor, oder eine Verfahreinheit, eine Verarbeitungseinheit, welche zumindest ein trainiertes künstliches neuronales umfasst, und eine Aufnahmeeinheit zum Erfassen zumindest eines Bildes, umfassen.

Mit von der Erfindung umfasst ist ferner ein Computerprogrammprodukt, welches direkt in einem Speicher einer Verarbeitungseinheit des Systems wie vorstehend beschrieben ladbar ist, mit Programmcode-Mitteln, um ein Verfahren zur Bearbeitung von Substraten, insbesondere von Wafern, Masken oder Flat Panel Displays, mit einer Maschine der Halbleiterindustrie auszuführen, wenn das Computerprogrammprodukt in der Verarbeitungseinheit ausgeführt wird.

Durch das erfindungsgemäße Verfahren zur Bearbeitung von Substraten, insbesondere von Wafern, Masken oder Flat Panel Displays, mit einer Maschine der Halbleiterindustrie, ergeben sich eine Vielzahl von Vorteilen. So können diese Maschinen auch bei hoher Komplexität hinreichend zuverlässig arbeiten, und die Maschine kann flexibel auf Schwankungen reagieren.

Ein großer Vorteil liegt weiterhin darin, dass die Algorithmen zur Bearbeitung von Kriterien zumindest nicht vollständig durch einen Anlagenbediener oder Programmierer vorgedacht werden müssen, bzw. starre Regeln erstellt werden müssen, sondern dass sich das künstliche neuronale Netz diese Algorithmen in einem Lernvorgang, dem Trainieren, selber erarbeitet.

Da dieser Lernvorgang selbstständig ablaufen kann, und dabei auch mit einer sehr großen möglichen Zahl von Iterationen, wobei sich bei jeder Iteration das Netzwerk mit einer bestimmten Lern-Rate weiter selbstständig optimiert, können wesentlich komplexere Parameter oder Einflussfaktoren vorgesehen werden, als es mittels manuell erstellter Regeln wirtschaftlich sinnvoll darstellbar ist.

Zudem können über eine entsprechend große Anzahl und geeignete Auswahl der Bilder, welche Aufnahmen der realen Objekte und deren Umgebung darstellen und welche zum Trainieren verwendet werden, sehr viele verschiedene Parameter berücksichtigt werden.

Zudem können diese Bilder, die zum Lernen verwendet werden, beispielsweise weiter mit Mitteln der Bildbearbeitung modifiziert werden, indem etwa das Bildrauschen, und/oder jeweils Kontrast, Helligkeit, Bildschärfe, Skalierung, Aspekt Rate, Rotation, Bildhintergrund, und/oder andere Bildparameter variiert werden, und somit beim Trainieren oder Anlernen die verschiedenen Parameter oder zumindest ein Teil davon bereits mit in den Lernprozess einbezogen werden.

Solche Verfahren sind beispielsweise bekannt unter dem Begriff "Augmentierung".

Im Ergebnis wird durch die Erfindung auf diese Weise ein trainiertes künstliches neuronales Netz zur Verfügung gestellt, welches die Substrate in verschiedensten Ausprägungen zuverlässiger erkennt (durch Klassifikation, durch Detektion, oder durch Prediktion) als eine regelbasierende Bildverarbeitung. Zudem kann dies mit geringerem Aufwand erreicht werden als bei einer regelbasierenden Bildverarbeitung.

Weiterhin ist das künstliche neuronale Netz weniger beschränkt auf die Auswertung diskreter Regionen wie die regelbasierende Bildverarbeitung, wenn ein Bild ausgewertet wird.

Dadurch können in die Auswertung durch das künstliche neuronale Netz auch vollständige analoge Bilder einbezogen werden, in denen ein Objekt erkannt werden kann, auch wenn sich das Objekt in abweichender Position in Bezug auf die gelernten Bilder befindet. Dies stellt einen großen Vorteil gegenüber einer regelbasierenden Bildverarbeitung dar, in der typischerweise eine diskrete Region für die Erkennung eines Objektes definiert ist. Sofern sich das Objekt dann durch eine Positionsabweichung außerhalb dieser Region befindet, kann es nicht erkannt werden.

Weiterhin ist es möglich, nicht nur die Erkennung des Objektes, also die Präsenz des Objektes (Klassifikation), oder seine Orientierung zu erkennen, sondern auch seine Position, insbesondere seine ungefähre Position (Detektion). Bei der Detektion kann dann beispielsweise eine sogenannte "Bounding-Box" für das erkannte Objekt durch das künstliche neuronale Netz zuerst angelernt werden, und dann in der Anwendung die zumindest ungefähre Position des Objektes mit der "Bounding-Box" gekennzeichnet werden.

Die Erfindung ermöglicht eine Erkennung eines Substrates, beispielsweise einer Maske, eines Wafers oder Flat Panel Displays, sowie auch die Bestimmung der Position oder der Größe des Subjektes bei verschiedenen Beleuchtungsverhältnissen, bei unterschiedlichen Farben des Substrates oder des Hintergrundes, oder auch bei unterschiedlichen Bildschärfe, beispielsweise infolge von auftretenden Vibrationen während der Bildaufnahme, bei Lichteinstreuungen aus der Umgebung oder bei kleineren, in einem Toleranzbereich liegenden Abweichungen der Position oder der Lage des Substrates.

Die Erfindung wird nachfolgend anhand bevorzugter Ausführungsformen und unter Bezugnahme auf die beigefügten Figuren detaillierter beschrieben.

### Die Zeichnungen zeigen:

- Fig. 1: schematisch ein Ausführungsbeispiel mit einer geöffneten Kassette für die Aufnahme von Wafern mit korrekt angeordneten Wafern und einer Aufnahmeeinheit,
- Fig. 2: schematisch ein Bild der geöffneten Kassette aus Fig. 1,
- Fig. 3: schematisch den Ablauf des Trainierens und Anlernens des künstlichen neuronalen Netzes an einem Ausführungsbeispiel einer Kassette mit Wafern bestückten Kassette,
- Fig. 4: schematisch den Aufbau eines "CNN"-Netzwerkes der Kassettenbelegung in einer stark vereinfachten Darstellung,
- Fig. 5a: schematisch die Anwendung des trainierten künstlichen neuronalen Netzes zur Erkennung einer Kassettenbelegung,
- Fig. 5b: schematisch einen Ausschnitt einer Klassifikationstabelle anhand eines Ausführungsbeispiels,
- Fig. 6: schematisch ein Ausführungsbeispiel eines weiteren Aufbaus mit einer Aufnahmeeinheit und einer Beleuchtungseinheit,
- Fig. 7: schematisch ein Ausführungsbeispiel für eine geeignete Software-Architektur,
- Fig. 8: schematisch ein Ausführungsbeispiel für eine Rechnerarchitektur,
- Fig. 9: schematisch ein Ausführungsbeispiel einer geöffneten Kassette mit Wafern in korrekter Lage und in Fehllage,
- Fig. 10: schematisch ein Ausführungsbeispiel einer Aufnahme für Wafer mit einem aufgelegten Wafer in korrekter Lage,
- Fig. 11a, 11b: schematisch ein Ausführungsbeispiel einer Aufnahme für Wafer mit einem aufgelegten Wafer in korrekter Lage (Fig. 11a) und in Fehllage (Fig. 11b),
- Fig. 12a, 12b: schematisch ein weiteres Ausführungsbeispiel einer Aufnahme für Wafer mit einem aufgelegten Wafer in korrekter Lage (Fig. 12a) und in Fehllage (Fig. 12b),
- Figs. 13a-13f: schematisch ein weiteres Ausführungsbeispiel einer Aufnahme für Wafer mit unterschiedlichen Ausbildungen des Pellicle,
- Figs. 14a-14f: schematisch ein Ausführungsbeispiel für eine Bilderkennung auf Basis für Wafer mit unterschiedlichen Ausbildungen des Pellicle,
- Figs, 15a, 15b: schematisch ein weiteres Ausführungsbeispiel mit unterschiedlicher Anordnung der Aufnahmeeinheit,
- Fig. 16: schematische eine Ansicht eines Systems zur Prozessierung von Halbeiterbauelementen,
- Fig. 17: ein Ausführungsbeispiel mit einem einzigen Kameragehäuse mit zwei Kameras,
- Fig. 18: ein Ausführungsbeispiel, bei welchem eine Kamera mit integrierter Beleuchtung in einem Endeffektor integriert ist,
- Fig. 19: eine weitere Ausführungsform der Erfindung, bei welcher die Kameras an den Armen des Endeffektors angeordnet sind,
- Fig. 20: eine Seitenansicht und eine Draufsicht von oben auf wesentliche Bestandteile einer Maschine der Halbleiterindustrie zur Prozessierung von Halbleiterbauelementen,
- Fig. 21: die in Fig. 20 dargestellte Anlage im Ruhezustand in einer Draufsicht,
- Fig. 22: die in Fig. 20 dargestellte Anlage im Betriebszustand in einer Draufsicht,
- Fig. 23: die in Fig. 20 dargestellte Anlage in einem weiteren Betriebszustand in einer Draufsicht
- Fig. 24a, 24b: jeweils ein Ausführungsbeispiel eines Substrates mit einem Aufbau am Beispiel einer Maske,
- Fig. 25a, 25b: jeweils ein Ausführungsbeispiel eines Substrates mit einem Substrathalter am Beispiel eines Wafers, und
- Fig. 26: ein Ausführungsbeispiel mit einer oberen und unteren Schale.

### Detaillierte Beschreibung bevorzugter Ausführungsfonnen

Bei der nachfolgenden detaillierten Beschreibung bevorzugter Ausführungsformen bezeichnen um der Klarheit willen gleiche Bezugszeichen im Wesentlichen gleiche Teile in oder an diesen Ausführungsformen. Zur besseren Verdeutlichung der Erfindung sind die in den Figuren dargestellten bevorzugten Ausführungsformen jedoch nicht immer maßstabsgerecht gezeichnet.

Die Erfindung betrifft allgemein eine Maschine der Halbleiterindustrie zur Bearbeitung eines Substrates, insbesondere eines Wafers, einer fotolithographischen Maske oder eines Flat Panel Displays. Das Bearbeiten kann dabei das Transportieren eines Substrates zwischen zwei oder mehreren Stationen betreffen, beispielsweise einem Ablageort oder einer Bearbeitungsstation, oder auch das Prozessieren eines Substrates.

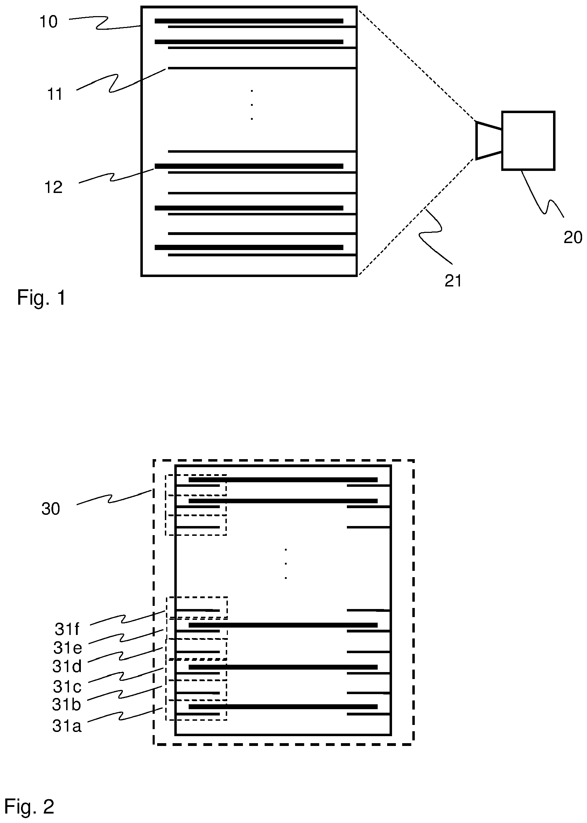

Fig. 1 zeigt schematisch ein Ausführungsbeispiel mit einem Speicher 10 in Form einer geöffneten Kassette für die Aufnahme von Substraten 12, im Ausführungsbeispiel zur Aufnahme von Wafern, in einer Draufsicht.

In dem Ausführungsbeispiel ist nur ein Ausschnitt des Speichers 10 dargestellt, welcher über insgesamt 25 einzelne Ablageorte 11 bzw. Slots für die Aufnahme jeweils eines einzelnen Substrats 12 verfügt.

In dem Ausführungsbeispiel sind lediglich 9 derartige Ablageorte 11 eingezeichnet. Von den Ablageorten 11 sind in dem Beispiel fünf Ablageorte 11 mit Substraten 12 belegt und vier Ablageorte 11 sind nicht belegt. In dem Ausführungsbeispiel sind sämtliche Ablageorte 11, welche belegt sind, korrekt belegt. In anderen Worten, sämtliche Wafer 12 sind korrekt und fehlerfrei abgelegt.

Die Rechnerarchitektur und die Maschine der Halbleiterindustrie ist in diesem Ausführungsbeispiel nicht dargestellt.

Die Maschine der Halbleiterindustrie kann einen Roboter umfassen, welcher ein bewegliches Element, bevorzugt einen Roboterarm und/oder einen Endeffektor, umfassen kann. Ferner kann die Maschine der Halbleiterindustrie auch eine Verfahreinheit umfassen, welche zum Bewegen oder Transportieren des Substrates verwendet werden kann. Das Substrat kann nicht nur Wafer wie im Ausführungsbeispiel, sondern auch beispielsweise Masken oder Flat Panel Displays umfassen.

Die Maschine der Halbleiterindustrie kann demzufolge eine Einrichtung zum Aufnehmen und/oder Bewegen und/oder zum Ablegen des Substrates umfassen. Das abgebildete Ausführungsbeispiel zeigt demnach einen Ausschnitt eines erfindungsgemäßen Systems.

Die gestrichelte Linie 21 markiert den Aufnahmebereich der Aufnahmeeinheit 20. In dem Beispiel handelt es sich bei der Aufnahmeeinheit 20 um eine Kamera.

Die Aufnahmeeinheit 20 erfasst den abgebildeten Bildbereich, im Beispiel also die gesamte, geöffnete Kassette, und erzeugt eine digitale Darstellung, welche dem künstlichen neuronalen Netz zur Verfügung gestellt wird.

Die Aufnahmeeinheit 20 kann dabei neben der gezeigten bildgebenden Kamera einen optischen Sensor, einen Ultraschall-Sensor, einen Abstands-Sensor, einen Reflex-Sensor, ein Radar-Sensor, eine Video-Kamera, oder eine Infrarotkamera umfassen.

Das erzeugte Bild wird einem künstlichen neuronalen Netz zugeführt, um die Präsenz und/oder die Position und/oder die Orientierung des Substrates zu ermitteln und um hierauf basierend durch das künstliche neuronale Netzeinen Informationsdatensatz umfassend eine Information über die ermittelte Präsenz und/oder Position und/oder Orientierung und/oder des Typs des Substrates und/oder ein Steuerbefehl zu erzeugen, welcher dazu dient, die Maschine der Halbleiterindustrie direkt zu steuern, oder von der Steuerung der Maschine verwendet wird oder an ein übergeordnetes Steuerungssystem weitergegeben wird.

Der Informationsdatensatz kann auch zusätzlich oder alternativ an einen Bediener weitergegeben werden, der aus dieser Information Rückschlüsse für sein Handeln zur Bedienung der Maschine zieht, oder der diese Information an Steuerungen oder andere Bediener weitergeben kann, oder der Informationsdatensatz kann für eine spätere oder weitere Auswertung gespeichert werden.

Der Informationsdatensatz umfasst demnach eine Information,
aus welcher die Präsenz des Substrates in einem Slot, oder auf einer Auflage, oder auf einem Roboter, oder auf einem Endeffektor, oder auf einer Bearbeitungsstation in der Maschine, oder an einem anderen Ort, wo sich die Maske in der Maschine der Halbleiterindustrie befinden kann,
und/oder die räumliche Orientierung des Substrates in Bezug auf die zu einem Roboter der Maschine gerichtete Seite eines Slots, oder in Bezug zu einer Auflage, oder im Bezug zu einer Bearbeitungsstation, oder im Bezug zu einem anderen Teil der Maschine,
und/oder die räumliche Lage des Substrates zu einem Slot, oder zu einer Auflage, oder zu einem Roboter, oder zu einem Endeffektor, oder zu einem anderen Ort, wo sich das Substrat in der Maschine der Halbleiterindustrie befinden kann,
und/oder des Typs des Substrates,
und/oder die Präsenz eines Pellicles auf einem Substrat, insbesondere auf einer Maske,
und/oder die Seite eines abgelegten Substrates, insbesondere einer Maske, auf der sich ein Pellicle befindet
und/oder die Orientierung eines Pellicles in Bezug zu einer Referenzachse einer Auflage, einer Kassette, eines Roboters, eines Endeffektors,
und/oder die Präsenz und/oder die Position und/oder die Orientierung eines Substrates,
   ermittelt werden kann oder ableitbar ist.

Es ermöglicht damit, Fehllagen des Substrates 12 zu erkennen, umfassend
ob die Fehllage ein über mehrere Etagen einer Auflage liegendes Substrat 12 betrifft, und/oder ob die Fehllage mindestens zwei direkt übereinander liegende Substrate 12 betrifft, und/oder ob die Fehllage eine Abweichung von einer vorgegebenen Soll-Lage eines Substrates 12 betrifft, und/oder
ob die Fehllage ein nicht auf allen vorgesehenen Auflagepunkten einer Auflage korrekt aufliegendes Substrat 12 betrifft.

Das Substrat 12 kann dabei beispielsweise in Kassetten, wie im Ausführungsbeispiel gezeigt, und/oder auf Auflagen und/oder auf einem Endeffektor und/oder auf einem Chuck und/oder auf einer Bearbeitungsstation der Maschine und/oder auf einer Verfahreinheit befinden.

Durch das künstliche neuronale Netz kann auch mehr als ein Bild erfasst werden, insbesondere zumindest zwei Bilder, vorzugsweise des gleichen Ortes, welche aber von unterschiedlichen Aufnahmeeinheiten und/oder unterschiedlich angeordneten Aufnahmeeinheiten erzeugt werden.

Fig. 2 zeigt schematisch ein Bild bzw. ein Gesamtbild 30 der geöffneten Kassette aus Fig. 1 in einer Draufsicht.

Das Bild 30 ist in dem Beispiel in einzelne Bilder unterteilt, welche jeweils einen Ablageort 11 bzw. einen Slot zeigen. In dem abgebildeten Beispiel sind der Übersichtlichkeit halber die untersten sechs Slot-Bilder 31a, 31b, 31c, 31d, 31e und 31f gekennzeichnet.

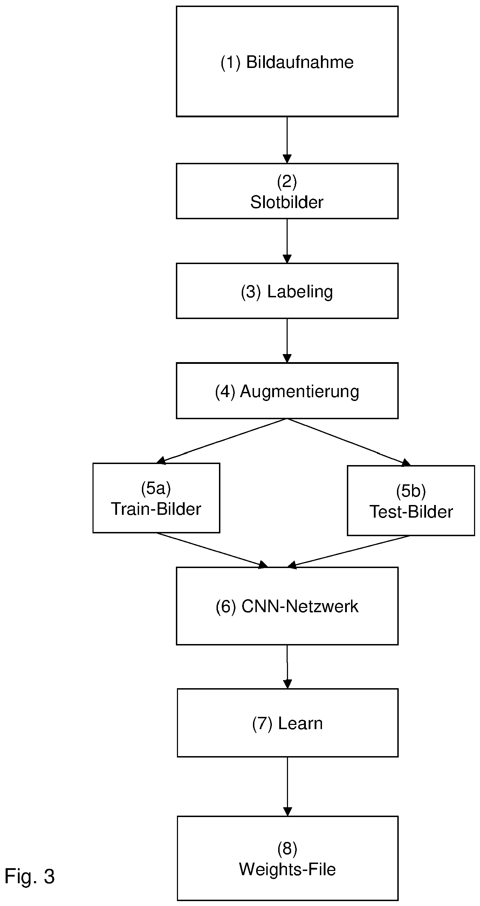

Fig. 3 zeigt schematisch den Ablauf des Trainierens des künstlichen neuronalen Netzwerkes an einem Ausführungsbeispiel einer mit Substraten 12, im Beispiel mit Wafern, bestückten Kassette. Die einzelnen Schritte sind mit (1) bis (8) gekennzeichnet und sollen nachstehend dargestellt werden.

In einem ersten Schritt (1) erfolgt eine Bildaufnahme von einem oder mehreren Bildern der geöffneten Kassette mit 25 Ablageorten für Wafer und bei verschiedenen Slot-Belegungen. Hierzu können auch Bilder aus verschiedenen Blickwinkeln aufgenommen werden.

In einem zweiten Schritt (2) werden hieraus die im Beispiel 25 einzelnen Slot-Bilder erzeugt. Dies kann manuell durch Bildausschnitte aus dem Gesamtbild 30 erfolgen; es ist aber beispielsweise auch möglich, Bildbereiche des Gesamtbildes 30 durch die "Bounding-Boxen" zu erzeugen, welche dann durch das künstliche neuronale Netz verarbeitet werden können. Die Bildausschnitte können leicht zu verschiedenen Größen variiert werden; die optimale Größe hängt unter anderem von der Auslegung des künstlichen neuronalen Netzes ab.

In einem dritten Schritt (3) erfolgt ein sogenanntes "Labeling", d.h. eine Zuweisung zu Klassen: belegter Slot oder freier Slot. Diese Klassifizierung kann manuell erfolgen. Beispielsweise können die Bilder in verschiedenen Ordnern abgelegt werden, welche den Klassen zugeordnet sind; es ist aber beispielsweise auch möglich, die Labels wie auch "Boundingboxen" in jeweils den Einzelbildern zugeordneten separaten Dateien zuzuweisen. Wenn weitere Klassifizierungen - wie beispielsweise der Typ des Substrates, und/oder "cross-slotted" Wafer, und/oder "double-slotted" Wafer - ermittelt werden sollen, werden diese Klassen hier ebenso definiert.

In einem vierten Schritt (4) erfolgt die Erzeugung von verschiedenen Ausprägungen der Parameter durch Augmentierung der Slot-Bilder. Im Ausführungsbeispiel werden die Bilder in dem Parameter Helligkeit augmentiert, in anderen Worten es erfolgt eine Variierung der Bildhelligkeit der Bilder zum Trainieren, um Helligkeitsschwankungen der Bilder bei der Anwendung des künstlichen neuronalen Netzes in das Trainieren einfließen zu lassen. Auch in der Skalierung wird augmentiert, in anderen Worten, es erfolgt eine Variierung der Größe der Abbildung ähnlich einem Zoom, um Schwankungen der Größe der abgebildeten Slots und Wafers in Bildern bei der Anwendung des künstlichen neuronalen Netzes, etwa durch geringe lagetoleranzbedingte Entfernungsunterschiede der Wafer und Slots zur Aufnahmeeinheit, in das Trainieren einfließen zu lassen.

Das Durchführen einer derartigen Augmentierung ist nicht zwingend. Die Anzahl der Bilder zum Trainieren des künstlichen neuronalen Netzes beträgt in dem Ausführungsbeispiel etwa 150. Es können aber auch, etwa bei mehreren Parametern, die berücksichtigt werden sollen, und/oder bei mehreren möglichen Ausprägungen, deutlich mehr Bilder hilfreich sein, welche je nach Anwendung beispielsweise auch 10.000 betragen können.

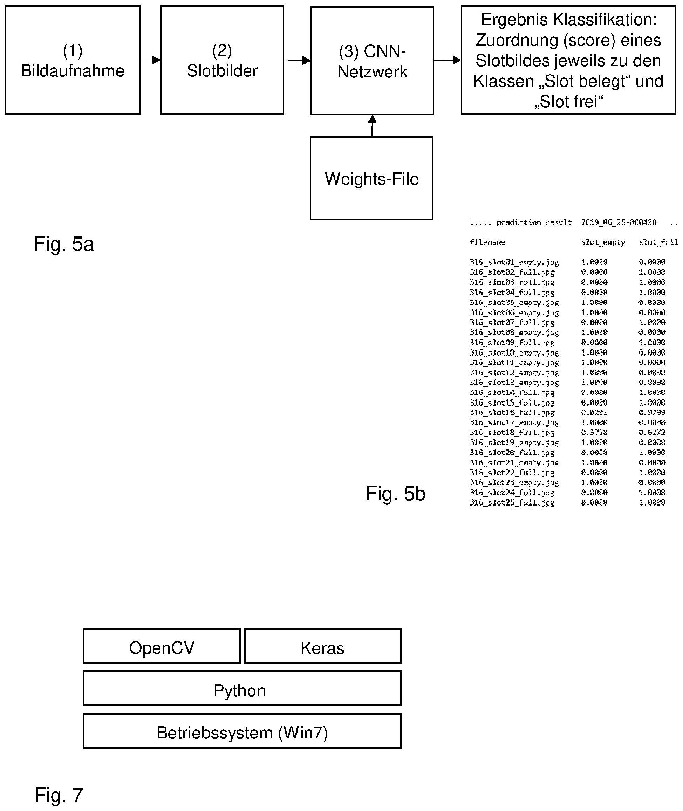

Im 5.Schritt werden die Bilder dann in Bilder zum Trainieren ("Train"), und zum Testen und validieren ("Test"-Bilder) der Iterationen des Trainingsvorganges aufgeteilt (Fig. 5a, 5b). Diese Zuordnung kann jedoch auch automatisch programmgesteuert erfolgen, wobei das künstliche neuronale Netz unterschiedliche Bilder nutzt, um in den einzelnen Trainingsdurchläufen ("Train"-Bilder) das Ergebnis mit anderen Bildern ("Test"-Bilder) zu testen und zu verifizieren.

In einem sechsten Schritt (6) wird das künstlichen neuronalen Netz konfiguriert bzw. erstellt. Im vorliegenden Beispiel wird ein "CCN"-Netzwerk ausgebildet, also ein "Convolutional" Neuronales Netzwerk, welches unter anderem convolutionale und neuronale Layer enthält. Im Beispiel verfügt dieses Netzwerk über zwei Ausgangsneuronen, für die beiden definierten Klassen (belegter Slot, und freier Slot) stehen. Sind weitere Klassen erforderlich, wie beispielsweise die Klassen "cross slotted" und/oder "double slotted" Wafer, und/oder Wafer mit Substrathalter, müssen entsprechende Neuronen hinzugefügt werden.

Im siebten Schritt (7) erfolgt der Lern-Vorgang. Das Netzwerk (6) führt den Lernvorgang mit den eingestellten Lernparametern (wie die Anzahl der Iterationen, auch "Epochs" genannt, Lernrate, und anderen für CNN Netzwerke bekannten Parametern durch.

Im Ergebnis des Lern-Vorganges wird schließlich im achten Schritt (8) das sogenannte "Weights-File" erzeugt, welches die Parametrisierung der einzelnen Elemente und Verbindungen des CNN-Netzwerkes enthält.

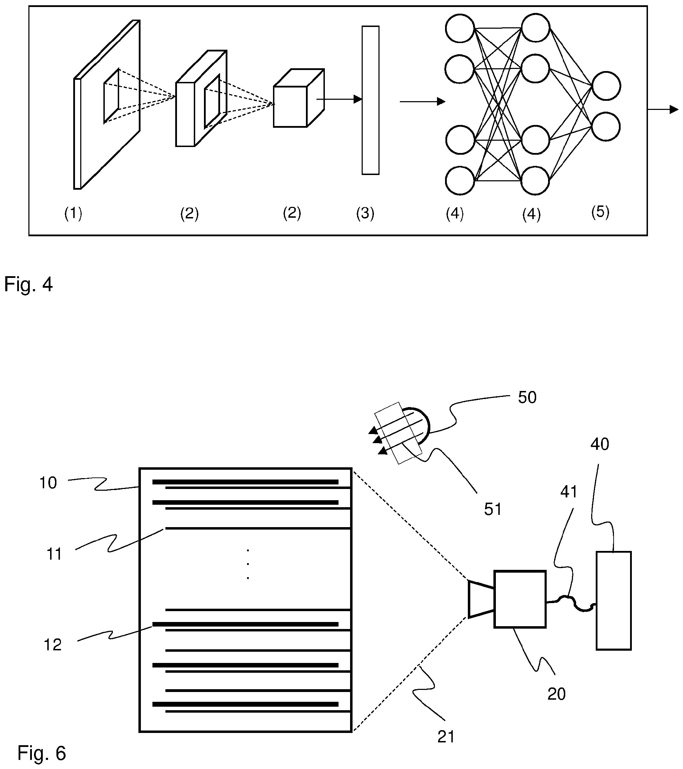

Fig. 4 zeigt schematisch den Aufbau dieses "CNN"-Netzwerkes bzw. ein Modell dieses Netzwerkes am Beispiel der Kassettenbelegung in einer stark vereinfachten Darstellung. Hierzu dazu die sogenannte "Keras"-Plattform verwendet, es gibt jedoch eine Vielzahl andere möglicher Plattformen, beispielsweise "Pytorch" oder andere, die verwendet werden können.

Mit den Bezeichnungen (1) bis (5) sind in der Fig. 4 die verschiedenen Layer oder Hierarchieebenen angegeben.
(1) Input Layer: hier wird das Bild in das Netzwerk eingelesen.
(2) Convolutional Layer(s): Auf das Bild wird ein Faltungsvorgang mit verschiedenen Filtern angewendet. Im Ausführungsbeispiel werden zwei Convolutional Layer verwendet, mit Filtergröße 3x3, Anzahl der Filter 32 und 64, ReLu Aktivierungsfunktion, Max Pooling mit Größe 2x2. Es ist jedoch eine Vielzahl anderer Konfigurationen möglich, etwa hinsichtlich der Anzahl der Layer, der Anzahl + Größe der Filter, oder der Aktivierungsfunktionen.
(3) Flatten Layer: Umwandlung des dreidimensionalen Ergebnisses des letzten Convolutional-Layers in ein eindimensionales Format zur Übergabe an die Neuronalen Layer.
(4) Neuronale Layer: es werden im Beispiel zwei neuronale Layer mit 128 und 64 Neuronen und ReLu Aktivierungsfunktion angewendet. Dropouts wurden eingesetzt, um eine Sättigung zu vermeiden. Es ist jedoch eine Vielzahl anderer Konfigurationen möglich, etwa hinsichtlich der Anzahl der Layer, der Anzahl der Neuronen, der Aktivierungsfunktionen, oder der Dropouts. Es ist auch möglich, ganz auf die Neuronalen Layer zu verzichten, was auch den Klassifikations-Layer betrifft. In diesem Fall kann die Klassifikation auch durch einen Convolutional-Layer erzeugt werden.
(5) Neuronaler Layer zur Klassifikation: Zwei Neuronen, für die Klassen Slot belegt und Slot frei. Im Lernprozess werden die Parameter des Netzwerkes durch iterativen Soll-Ist-Vergleich der erzeugten Klassifizierung optimiert, in der Anwendung der Klassifikation werden diese Parameter dann angewendet. Eine Softmax-Aktivierung wurde eingesetzt zur Erzeugung eines Float-Wertes zur Darstellung der Klassenzugehörigkeit des Bildes zu den beiden Klassen (ähnlich einem "Scoring", Slot frei, Slot belegt).

Fig. 5a zeigt schematisch die Anwendung des trainierten künstlichen neuronalen Netzes zur Erkennung einer Kassettenbelegung, und Fig. 5b ebenfalls schematisch einen Ausschnitt eines durch die Anwendung erzeugten Datensatzes mit Zuordnungen der einzelnen Slotbilder zu den Klassen "slot_empty" (slot ohne Wafer) und "slot_full" (Slot mit Wafer) zur Zugehörigkeit anhand des Ausführungsbeispiels, wobei die Zuordnung mit Werten zwischen 0 und 1 abgebildet ist.

Die einzelnen Schritte (1) bis (3) ergeben sich wie folgt:
(1) Ein Bild der geöffneten Kassette wird aufgenommen.
(2) Die einzelnen 25 Slot-Bilder werden erzeugt. Die entsprechenden Bildausschnitte der einzelnen 25 Slots werden automatisch aus dem Bild der geöffneten Kassette erzeugt. Dieses ist in dem gezeigten Ausführungsbeispiel und auch in praktischer Anwendung besonders gut möglich, wenn es eine feste geometrischen Zuordnung von Kamera und Kassette über vordefinierte Positionen gibt. Hier kann es sich also anbieten, dass die sich die Aufnahmeeinheit an dem Endeffektor eines Roboters befindet, welcher in die richtige Position für frontseitige Bildaufnahme der Kassette gefahren werden kann.

Es ist aber beispielweise auch möglich, die Lage der Kassette oder der Slots über beispielsweise Methoden der Objekt-Detektion, welche eine Ortserkennung umfassen, zu bestimmen, und daraus die Bildausschnitte abzuleiten.
(3) Das CNN-Netzwerk wie weiter oben beschrieben mit den Schritten "Trainieren des Netzwerkes" und "Aufbau des Netzwerkes" mit dem beim Anlernen des Netzwerkes erzeugten "Weights-File" parametrisiert. Die Slot-Bilder werden einzeln nacheinander im künstlichen neuronalen Netz analysiert, wobei die im Lernprozess erzeugte Filterung in den Convolutional Layern und die Verknüpfung in den Neuronalen Layern auf die einzelnen Bilder angewendet wird, und wobei durch den letzten Neuronalen Layer durch die den Klassen zugeordneten Neuronen die Zuordnung des Slot-Bildes zu den beiden Klassen (freier Slot, belegter Slot) vorgenommen wird. Dieser Vorgang wird auch als Klassifikation oder Prediktion bezeichnet.

Fig. 6 zeigt schematisch ein Ausführungsbeispiel eines weiteren Aufbaus mit einer Aufnahmeeinheit 20, einer Beleuchtungseinheit 50 sowie einer Rechnerarchitektur 40 in einer Draufsicht.

Die Aufnahmeeinheit 20 kann dabei dauerhaft fest, wie im Ausführungsbeispiel gezeigt, oder zeitweise fest in die Maschine integriert oder angebaut sein. Im Ausführungsbeispiel ist die Aufnahmeeinheit 20 dauerhaft fest im Umfeld der Maschine angeordnet. Die Verbindung mit der Rechnerarchitektur 40 kann in diesem Fall drahtgebunden mittels Kabel 41 erfolgen. Selbstverständlich sind auch drahtlose Verbindungen zwischen Rechnerarchitektur 40, Aufnahmeeinheit 20 und/oder Beleuchtungseinheit 50 möglich.

Die Aufnahmeeinheit 20 kann in Bezug auf die Maschine und/oder den Ort der Bildaufnahme ortsunveränderlich installiert sein, wie im Ausführungsbeispiel gezeigt. Die Aufnahmeeinheit 20 oder auch eine weitere zweite Aufnahmeeinheit 20 kann aber auch an beweglichen Elementen der Maschine angeordnet sein, bevorzugt an einem Roboterarm oder an einem Endeffektor eines Roboters oder an einer Verfahreinheit.

Im dargestellten Ausführungsbeispiel wurden die Bilder zum Trainieren und bei der Anwendung mit einer Kamera aufgenommen und an die Rechnerarchitektur übertragen.

Es ist aber beispielswiese auch möglich, vorhandene, gespeicherte Bilder aus Datenbanken zum Trainieren zu verwenden. Es ist auch möglich, die Aufnahmeeinheit 20 für Bild- oder Videoaufnahmen zum Lernen und zur Anwendung des künstlichen neuronalen Netzes direkt mit der Rechnerarchitektur zu verbinden, oder eine über ein Netzwerk angeschlossene Aufnahmeeinheit 20 zu verwenden.

Für bestimmte Anwendungsfälle kann bereits Raumbeleuchtung und damit das Umgebungslicht ausreichend sein. Im Allgemeinen ist es jedoch hilfreich, wenn eine Beleuchtungseinheit 50 wie im Ausführungsbeispiel gezeigt vorgesehen wird. Dies bietet sich insbesondere dann an, wenn innerhalb einer in der Regel geschlossenen Maschine, in die kein Umgebungslicht gelangt, Bilder aufgenommen werden sollen.

Die Beleuchtungseinrichtung 50 ist dazu vorgesehen, elektromagnetische Strahlung 51 in Richtung auf das Substrat oder den Ort in oder an der Maschine zu emittieren, vorzugsweise zu dem Zeitpunkt, wenn ein Bild erfasst wird. Dabei liegt die elektromagnetische Strahlung 51 bevorzugt zumindest im sichtbaren Wellenlängenbereich und/oder in einem Wellenlängenbereich, in dem die Aufnahmeeinheit sensitiv ist. Die Beleuchtungseinrichtung 50 kann eine Lampe, beispielsweise eine Lampe mit Leuchtdioden oder eine Halogenlampe umfassen.

Die Beleuchtungseinrichtung 50 kann dabei in die Maschine fest oder zeitweise integriert und/oder an der Maschine angebaut sein, oder auch in Bezug auf die Maschine ortsunveränderlich installiert sein, wie im vorliegenden Ausführungsbeispiel. Alternativ oder zusätzlich kann die Beleuchtungseinrichtung 50 sich an beweglichen Elementen der Maschine befinden, bevorzugt an einem Roboterarm oder an einem Endeffektor eines Roboters oder an einer Verfahreinheit.

Die Rechnerarchitektur 40 kann unterschiedliche Rechnerkonfigurationen umfassen, beispielsweise einen PC, einen Industrie-PC, einen Embedded Controller, zum Beispiel Raspberry Computer, oder eine speicherprogrammierbare Steuerung SPS.

Es versteht sich, dass diese Rechnerkonfigurationen entsprechend dimensioniert sein sollten, um die erforderliche Rechenleistung zur Verfügung stellen zu können. Idealerweise erfolgt die Bild-Analyse durch das künstliche neuronale Netz dabei in Echtzeit oder zumindest nahezu in Echtzeit. Es versteht sich ferner, dass die entsprechenden Schnittstellen zur Kommunikation vorhanden sein sollten.

Fig. 7 zeigt schematisch ein Ausführungsbeispiel für eine geeignete Software-Architektur. Hierbei ist zu berücksichtigen, dass eine Vielzahl von Betriebssystemen, Umgebungen und Bibliotheken verfügbar sind, welche für das erfindungsgemäße Verfahren dienlich sein können. Die abgebildete Software-Architektur stellt damit nur ein Ausführungsbeispiel unter mehreren möglichen dar.

In dem Ausführungsbeispiel umfasst die Software-Architektur eine "Opencv"-Bibliothek. Diese wird verwendet zum Einlesen von Bildern, zur Verarbeitung von Bildern oder zur Generierung von Bildausschnitten. Alternativ können auch andere Bibliotheken oder Methoden für diese Aufgabe verwendet werden.

Ferner umfasst die Software-Architektur eine "Keras"-Bibliothek. Diese beinhaltet die für das Ausführungsbeispiel verwendeten Programmpakete des künstlichen neuronalen Netzes, wie beispielsweise zur Erstellung und Anwendung des CNN-Modells, oder zur Durchführung des Lernvorganges. Alternativ können auch andere Bibliotheken verwendet werden, wie beispielsweise "Pytorch", "Caffee", oder ähnliche.

Ferner umfasst die Software-Architektur in dem Ausführungsbeispiel eine "Python"-Umgebung zur Programmierung . Alternativ können auch andere Programmier-Umgebungen oder Programmiersprachen verwendet werden, wie beispielsweise C++, Java oder Mathlab.

Die vorstehend genannten Komponenten der Software-Architektur werden auch als Verarbeitungseinheit umfassend das künstliche neuronale Netz bezeichnet.

Schließlich basiert die Software-Architektur in dem Ausführungsbeispiel auf einem "Windows"-Betriebssystem. Alternativ können auch andere Betriebssysteme verwendet werden, wie beispielsweise Linux, MacOS für Apple-Computer oder Raspbian für Raspberry-Computer.

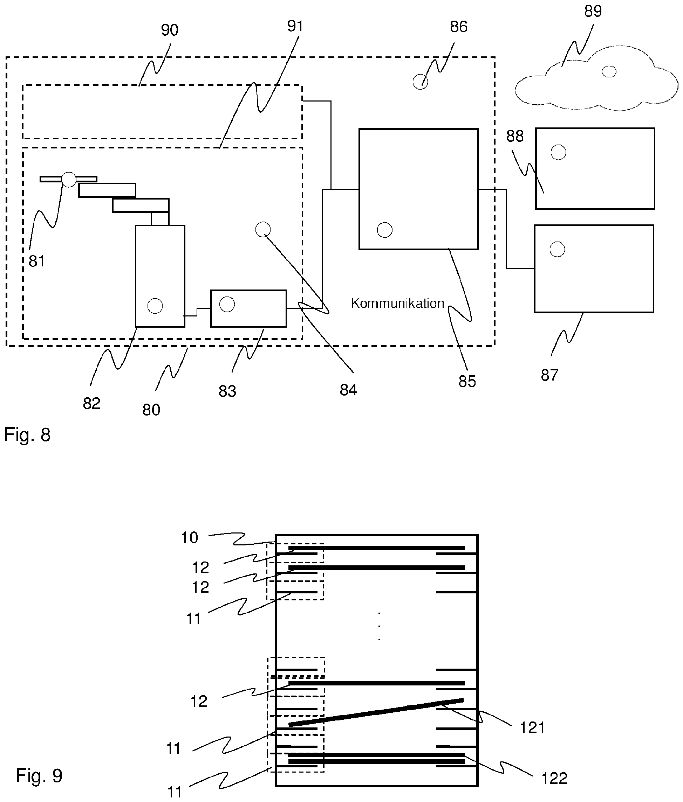

Fig. 8 zeigt schematisch ein Ausführungsbeispiel für den Aufbau einer Rechnerarchitektur und dessen Integration in eine Maschine der Halbleiterindustrie, welche in dem Beispiel mit einer gestrichelten Linie 80 markiert ist.

So ist es im Sinne der Erfindung möglich und auch vorgesehen, die Rechnerarchitektur bzw. die zugehörigen Komponenten, umfassend die Verarbeitungseinheit, die Rechner-Hardware und das Betriebssystem des Rechners in geeigneter Weise zentral oder dezentral zu implementieren.

Hierbei können die Bestandteile der Verarbeitungseinheit, die Hardware-Komponenten, die Programme, Datenbanken, die Bedienung, die Datenspeicherung, oder auch andere Komponenten entweder auf einem Rechner zentral liegen, oder auch auf mehreren Rechnern oder verschiedenen Stellen verteilt sein.

Dies gilt auch für die einzelnen Verfahrensschritte im Zusammenhang mit dem künstlichen neuronalen Netz, wie das Generieren von Daten für den Lernprozess, das Trainieren oder die Anwendung des Verfahrens zur Bearbeitung von Substraten.

Anhand eines Beispiels soll die Integration des künstlichen neuronalen Netzes für die Erkennung von Masken und Pellicles veranschaulicht werden.

In dem Beispiel ist eine Kamera auf einem Endeffektor 81 vorgesehen. Die mindestens eine Kamera nimmt sowohl Bilder auf, welche zum Trainieren des künstlichen neuronalen Netzes verwendet werden, als auch die Bilder, welche während des Betriebs der Anlage für die Erkennung von Masken / Pelliclen benötigt werden.

Die Bilder zum Trainieren werden auf einen anderen, externen Rechner 88 übertragen, auf dem die Verarbeitungseinheit installiert ist und wo im Beispiel das CNN-Modell vorhanden ist. Das "Weights-File" wird nach dem Trainieren auf einen Roboter-Controller 83 übertragen, wo ebenfalls eine Verarbeitungseinheit installiert und das CNN-Modell vorhanden sind.

In der Anwendung, also während des Betriebs der Maschine der Halbleiterindustrie 80, liest die Kamera im Endeffektor 81 die Bilder ein und überträgt sie auf den Roboter-Controller 83, wo dann die Analyse mittels des künstlichen neuronalen Netzes ausgeführt wird.

Als Ergebnis wird ein Informationsdatensatz generiert mit einer Information darüber, ob eine Maske vorhanden ist oder nicht, ob ein Pellicle vorhanden ist oder nicht, und ggf. die Lage und die Orientierung des Pellicle. Diese Information wird dann an den Systemcontroller 85 übergeben, wo sie von der dort laufenden Anwendersoftware der Maschinensteuerung verwendet wird.

Die Verarbeitungseinheit kann demnach in dem Roboter 82, in oder an dem Endeffektor 81 mit integrierter Verarbeitungseinheit, aber auch in dem Roboter-Controller 83 mit integrierter Verarbeitungseinheit, in einem Roboter-Handlingsystem 84 bzw. in dem Roboter-System 91 mit integrierter Verarbeitungseinheit, in einem System-Controller 85 mit integrierter Verarbeitungseinheit, in der Maschine der Halbleiterindustrie 86 mit integrierter Verarbeitungseinheit, in einer der Maschine nicht zugeordneten Steuerung 87 mit integrierter Verarbeitungseinheit, etwa einer Fabriksteuerung, oder einem anderen Rechner 88 mit integrierter Verarbeitungseinheit oder auch in einer Cloud 89 integriert sein.

Nachfolgend werden verschiedene Beispiele angegeben, welche verschiedene Arten von typischen Fehllagen von Substraten darstellen sollen.

So zeigt die Fig. 9 schematisch das Ausführungsbeispiel aus Fig. 1 mit einer geöffneten Kassette als Speicher 10 mit insgesamt drei Substraten 12 in korrekter Lage an jeweils einem Ablageort 11. Die Bezugszeichen 121 und 122 kennzeichnen jeweils ein Substrat 12 in Fehllage. Im Fall des Substrates 121 handelt es sich um einen Wafer, welcher in einer sogenannten "cross-slotted"-Lage aufgelegt ist, also schräg über zwei Ablageorte liegt. Im Fall des Substrates 122 handelt es sich um zwei Wafer, welcher in einer sogenannten "double-slotted"-Lage in einem Ablageort 11 liegen. In beiden Fällen handelt es sich um eine Fehllage, die ein weiteres Prozessieren der Substrate verhindern und ein manuelles Eingreifen durch einen Bediener erfordern kann.

Für die Erkennung der dargestellten Fehllagen werden beispielsweise
- Slot-Bilder mit korrekter Platzierung der Wafer aufgenommen
- Slot-Bilder mit der Fehllage "cross-slotted" aufgenommen
- Slot-Bilder mit der Fehllage "double-slotted" aufgenommen

Das Modell des künstlichen neuronalen Netzes kann mit den Klassen "Slot ohne Wafer", "Slot mit korrekt aufgelegten Wafer", "Slot mit double-slotted Wafer" und "Slot mit cross -slotted Wafer" definiert werden. Das Modell kann entsprechend trainiert und das "Weights-File" kann erstellt werden. Damit kann das künstliche neuronale Netz
zur Erkennung des Mappings der Kassette und von Fehllagen im Betrieb der Maschine verwendet werden.

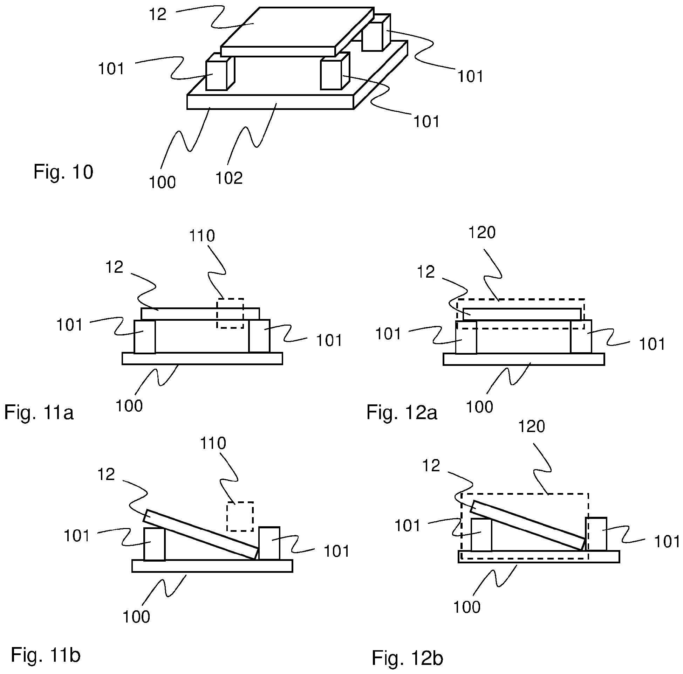

Fig. 10 zeigt schematisch ein Ausführungsbeispiel einer Auflage 100 für Substrate 12 mit aufgelegtem Substrat 12 in korrekter Lage in einer Schrägansicht. Die Auflage 100 umfasst insgesamt vier an den Ecken gelegene Aufnahmepunkte 101, auf denen bei korrekter Lage das Substrat 12, im Beispiel eine Maske, aufliegen soll.

Die Figuren 11a und 11b zeigen schematisch ein Ausführungsbeispiel der Aufnahme für Wafer mit einem aufgelegten Wafer in korrekter Lage (Fig. 11a) und in Fehllage (Fig. 11b), welches auf der Auflage 100 aus Fig. 10 basiert, in einer Draufsicht. Das Beispiel soll die im Stand der Technik vorherrschenden Probleme bei der Verwendung einer regelbasierenden Bildverarbeitung zur Erkennung einer Maske verdeutlichen.

Ein regelbasierendes Verfahren erfordert, wie im Beispiel gezeigt, die Festlegung eines diskreten Bereiches, welcher im Beispiel mit der gestrichelten Umrahmung 110 definiert ist. Während das aufgelegte Substrat 12 in Fig. 11a mittels des regelbasierenden Bilderkennungssystems erkannt werden kann, führt die Fehllage in Fig. 11b nicht dazu, dass ein Substrat 12 erkannt wird, da sich das Substrat 12 außerhalb des definierten, diskreten Bereiches 110 befindet.

Fig. 12a, 12b zeigen schematisch ein weiteres Ausführungsbeispiel einer Aufnahme für Wafer mit einem aufgelegten Wafer in korrekter Lage (Fig. 12a) und in Fehllage (Fig. 12b), wobei anstelle einer regelbasierenden Bilderkennung ein künstliches neuronales Netz verwendet wird. Dies kann ein CNN-Netzwerk sein wie weiter oben dargestellt, oder auch ein anderes. Zum Anlernen und zur Detektion kann bei einer Bilderkennung mittels künstlicher neuronaler Netz gemäß der Erfindung schematisch ein Bildausschnitt 120 der gesamten Maske verwendet. Auf diese Weise ist es möglich, dass auch ein Substrat 12 erkannt werden kann, welches deutlich von seiner Soll-Lage abweicht. In diesem Beispiel weist das Substrat 12 hinreichende Merkmale eines typischen Substrates 12 auf, welches eine Zuordnung, auch bei einer deutlichen Fehllage, erlaubt.

Die Maske in dem Beispiel der Fig. 12b wird demnach erkannt, obwohl sie eine Fehllage hat. Je nach Auslegung des künstlichen neuronalen Netzes kann auch eine Klassifikation erfolgen, dass es eine Maske mit Fehllage ist.

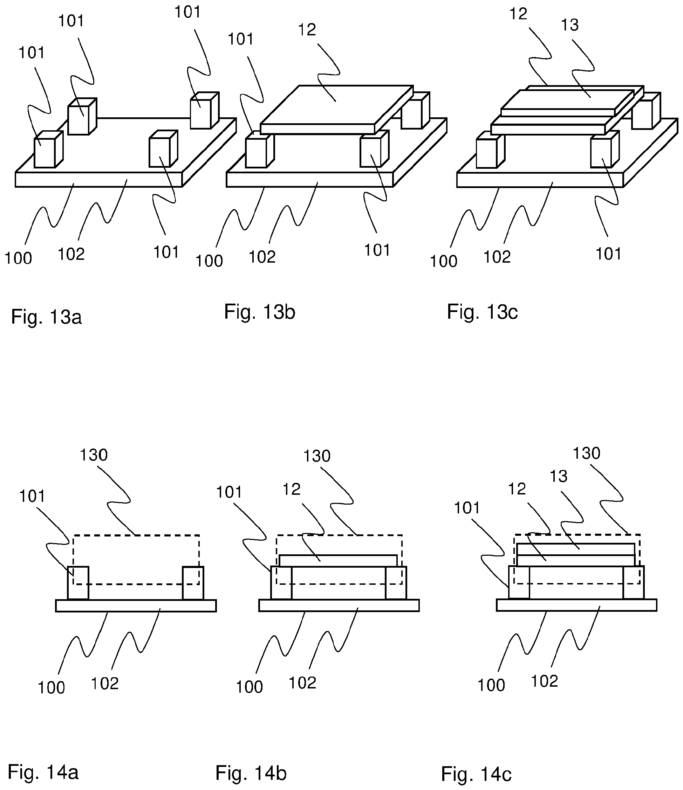

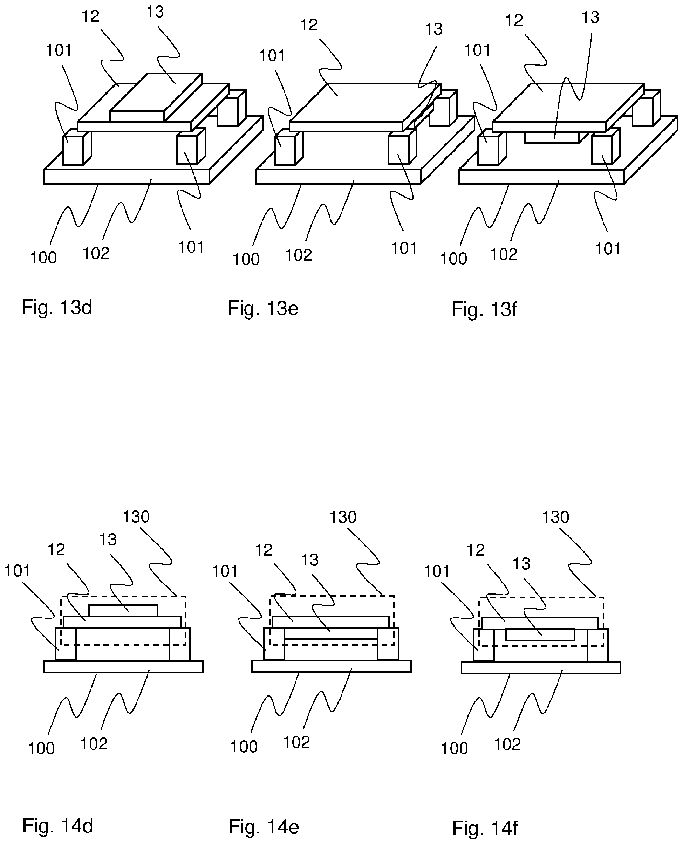

Die Figuren 13a, 13b, 13c, 13d, 13e und 13f zeigen schematisch verschiedene typische Ausführungsformen einer Auflage 100 für Substraten 12 in einer Schrägansicht. Im vorliegenden Beispiel handelt es sich bei dem Substrat 12 um eine Maske, welche ohne Pellicle 13 (Fig. 13b) bzw. mit Pellicle 13 (Figs. 13c bis 13f) gezeigt ist. Fig. 13a zeigt die Auflage 100 ohne Substrat 12.

In Fig. 13c ist das Pellicle 13 oben auf der Maske quer zur Vorderseite 102 der Auflage 100 angeordnet. In anderen Worten, die Maske mit dem Pellicle ist so orientiert, dass das Pellicle quer auf der Oberseite liegt. In Fig. 13d ist das Pellicle 13 oben auf der Maske längs angeordnet. In Fig. 13e ist das Pellicle 13 unten auf der Maske quer zur Vorderseite 102 der Auflage 100 angeordnet, in Fig. 13f schließlich ist das Pellicle 13 unten auf der Maske längs angeordnet. Die Bezeichnungen "oben" bzw. "unten" bezieht sich dabei auf ein abgelegtes Substrat, wobei "unten" dann zum Boden hinweist. Die Bezeichnungen "längs" und "quer" beziehen sich auf die Vorderseite 102 der Auflage 100.

Die Figuren 14a, 14b, 14c, 14d, 14e und 14f zeigen dazu korrespondierend schematisch die jeweiligen Bildausschnitte 130, welche das künstliche neuronale Netz zur Pellicle Detektion verwendet. Es wären auch Teile der dargestellten Bildausschnitte möglich und hinreichend, sofern diese die Situation eindeutig beschreiben; beispielsweise wäre auch die rechte oder linke Hälfte der Bilder ausreichend.

Im Beispiel der Fig. 14a, korrespondierend zu dem Beispiel der Fig. 13a, wird etwa erkannt, dass kein Substrat 12 auf der Auflage 100 vorhanden ist, im Beispiel der Fig. 14b wird ein Substrat ohne Pellicle erkannt, korrespondierend zu dem Beispiel der Fig. 13b.

Die vorstehend erläuterten Beispiele zeigen allein anhand zweier einfacher Parameter "Substrat vorhanden/nicht vorhanden", sowie "Pellicle vorhanden/nicht vorhanden" bzw. in welcher Lage ein erkanntes Pellicle vorliegt, die Komplexität, die ein regelbasierendes Verfahren erfordern würde, bei dem jede Lage in entsprechenden Regeln hinterlegt werden müsste.

Ändert sich dann ein Systemparameter, beispielsweise dahingehend, dass sich die Umgebungslichtbedingungen ändern, weil die Maschine in einer anderen Umgebung eingesetzt wird, oder sich Material oder optische Eigenschaften von Substraten oder Pelliclen ändern, müssten sämtliche Regeln neu definiert und hinterlegt werden, was zu einem immensen Aufwand führen kann.

So ist es beispielsweise auch denkbar, dass ein neuer Endeffektor in der Maschine der Halbleiterindustrie installiert wird, welcher auch über eine zusätzliche rotatorische Achse verfügt, welche ansteuerbar ist, und wodurch es ermöglicht wird, auch leicht schräg liegende Substrate 12 zu greifen und zu transportieren kann. Wenn dann auf diese Weise es ermöglicht wird, beispielsweise auch Substrate bis zu einer Schräglage des Substrates in einem Winkel von bis zu 2°, 5° oder 7° gegenüber der Horizontalen, zu greifen, den Schräglage zu korrigieren oder zu transportieren, können derartige neue Regeln sehr einfach definiert und hinterlegt werden.

Die Verwendung eines künstlichen neuronalen Netzes im Sinne der Erfindung ermöglicht es dagegen, anhand einiger Bilder, die die entsprechenden Schräglagen des Substrates 12 zeigen, und/oder sich ändernde Systemparameter, das künstliche neuronale Netz neu bzw. ergänzend zu trainieren und damit die Effizienz der Maschine der Halbleiterindustrie signifikant und in kurzer Zeit zu verbessern.

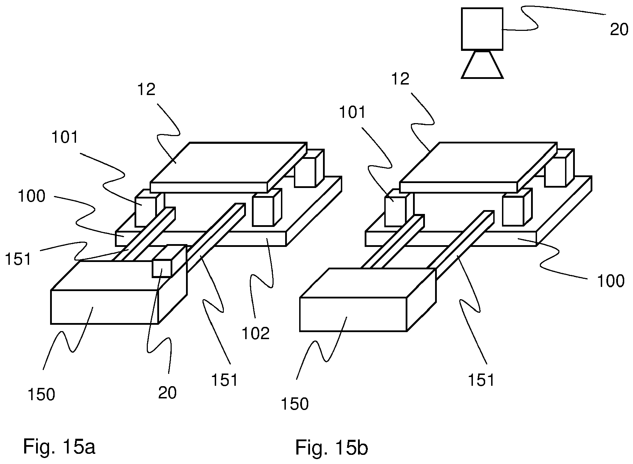

Die Figuren 15a und 15b zeigen schematisch ein weiteres Ausführungsbeispiel mit unterschiedlicher Anordnung der Aufnahmeeinheit 20 in einer Schrägansicht.

In dem Ausführungsbeispiel der Fig. 15a ist die Aufnahmeeinheit 20, im Beispiel eine bildgebende Kamera, an einem Endeffektor 150 angeordnet. Von Vorteil ist sie derart angeordnet, dass zumindest ein Greifarm 151 im Bildfeld der Aufnahmeeinheit 20 liegt.

In dem Ausführungsbeispiel der Fig. 15b ist die Aufnahmeeinheit 20, im Beispiel ebenfalls eine bildgebende Kamera, an einer nicht veränderlichen Stelle in der Maschine der Halbleiterindustrie angebracht.

Von Vorteil ist die Aufnahmeeinheit 20 derart angeordnet, dass zumindest die relevanten Objekte, insbesondere die Auflage 100, oder der Roboter oder ein bestimmter Bereich von Interesse im Bildfeld der Aufnahmeeinheit 20 liegt.

Der Roboter und der Roboterarm sind in den Ausführungsbeispielen der Übersichtlichkeit halber nicht gezeigt. Es können auch mehrere Aufnahmeeinheiten 20 in verschiedenen Ausrichtungen angebracht werden, deren Bilder zusammengesetzt und dann ausgewertet werden, oder deren Bilder einzeln ausgewertet werden, und dann die Ergebnisse der Auswertung miteinander verbunden werden.

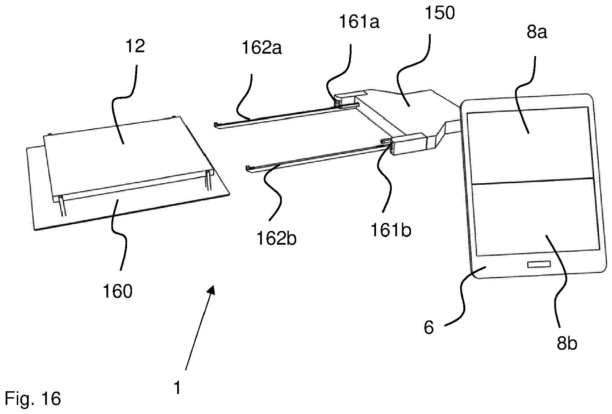

Fig. 16 zeigt in einer schematischen Ansicht ein System 1 zur Prozessierung von Halbeiterbauelementen.

Das System 1 umfasst einen Endeffektor 150 mit den Armen 162a, 162b über die ein Substrat 12, im Beispiel eine Maske oder ein Wafer, auf einer Ablage 160 abgesetzt und/oder aufgenommen werden kann.

Der Endeffektor 150 ist Teil eines Roboters (nicht dargestellt) und wird über den Roboter in mehreren Raumrichtungen bewegt. Insbesondere kann ein Roboter mit einer Radial- und Theta-Achse verwendet werden.

Gemäß der Erfindung umfasst das System zumindest eine Aufnahmeeinheit, welche in diesem Ausführungsbeispiel mitbewegend am Endeffektor 150 angeordnet ist.

In diesem Ausführungsbeispiel sind zwei Kameras 161a, 161b, als Aufnahmeeinheit vorgesehen. Die optischen Achsen der zwei Aufnahmeeinheiten können in einem Winkel zueinander stehen, oder auch parallel zueinander ausgerichtet sein. In dem Ausführungsbeispiel sind die beiden optischen Achsen der beiden Aufnahmeeinheiten parallel zueinander ausgerichtet, aber seitlich voneinander versetzt, um beide Arme 161a, 161b abbilden zu können.

Die Kameras 161a, 161b, befinden sich in diesem Ausführungsbeispiel vorne am Endeffektor 150 zwischen oder neben den Armen 162a, 162b.

Das Bild der Kameras 161a, 161b wird an ein elektronisches Gerät, in diesem Ausführungsbeispiel an ein tragbares Tablet 6, übertragen.

In diesem Ausführungsbeispiel sind auf dem Tablet die Ansichten der Kameras 161a, 161b getrennt als Ansicht 8a und Ansicht 8b dargestellt. Die kann beispielsweise über einen geteilten Bildschirm realisiert sein.

Beispielsweise ist es möglich, dass die Kamera 161a auf den Arm 162a gerichtet ist, wohingegen die Kamera 161b auf die vordere Kante des Substrates 12 gerichtet ist.

So kann zum einen über die Kamera 161a der Bewegungsverlauf des Endeffektors 150 kontrolliert werden.

Über die Kamera 161b kann auf einfache Weise festgestellt werden, wenn es zu einem Versatz beim Aufnehmen oder Ablegen des Substrates 12 kommt, oder ob sich das Substrat 12 in einer Position befindet, beispielsweise in einer Schräglage von 5°, welche noch ein Prozessieren ermöglicht.

Weiter kann über die Kameras 161a, 161b überprüft werden, ob sich ein Substrat 12 auf dem Endeffektor 150 befindet.

Auf weitere Sensoren kann so verzichtet werden.

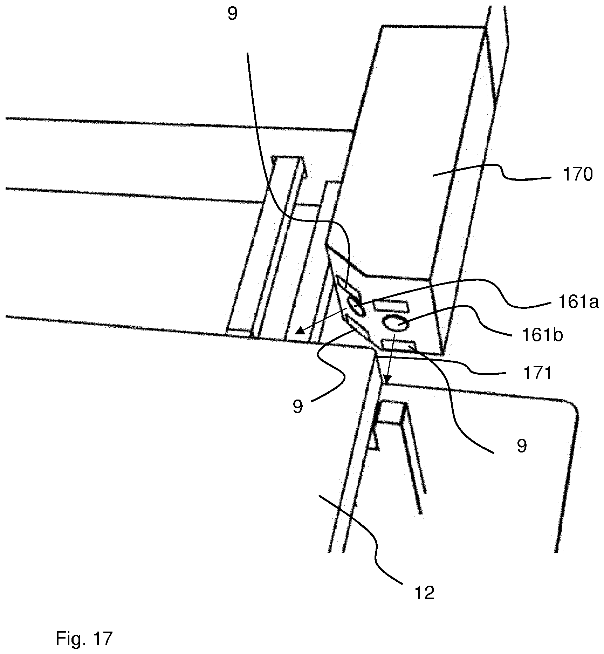

Fig. 17 zeigt ein Ausführungsbeispiel, bei welchem in einem einzigen Kameragehäuse 170 zwei Kameras 161a, 161b an einer Ecke angeordnet sind.

Zu erkennen ist, dass jede der Kameras 161a, 161b die von der Ecke 171 ausgehende Kante aufnimmt. Von Vorteil sind die beiden Kameras 161a, 161b derart angeordnet, dass ihre Blickrichtungen bzw. ihre optischen Achsen nicht parallel zueinander stehen, sondern einen Winkel zueinander bilden.

Der Winkel der optischen Achsen kann dabei in einer Ebene gebildet werden, welche durch die beiden Arme 162a und 162b, also der Greifvorrichtung des Endeffektors, vorgegeben ist. Im Ausführungsbeispiel liegt die optische Achse der zumindest einen Aufnahmeeinheit in dieser Ebene, zumindest den einen Arm 162a, 162b gut abbilden zu können. Es ist aber auch möglich, dass die optische Achse der zweiten Aufnahmeeinheit nicht in dieser Ebene liegt. So kann etwa auch bei Annäherung an ein Objekt früher festgestellt werden, ob eine Kollision droht.

Dieser Winkel kann unterschiedlich ausgeführt sein und liegt von Vorteil zwischen 5° und 90°, bevorzugt zwischen 10° und 80° und besonders bevorzugt zwischen 15° und 75°. Im Beispiel beträgt der Winkel zwischen etwa 20° bis 30°. Diese Bauweise ermöglicht einen besonders kompakten Aufbau des Kameragehäuses 170 und damit eine einfache und platzsparende Montage an dem Endeffektor.

So kann ebenfalls auf einfache Weise ein Versatz beim Aufnehmen oder Ablegen festgestellt werden.

Vorzugsweise ist das Kameragehäuse 170 am Endeffektor angebracht.

Auf diese Weise kann eine kompakte, einfach zu integrierende Möglichkeit geschaffen werden, die Aufnahmeeinheiten am Endeffektor anzuordnen, so dass sie mit dem Endeffektor bewegt werden können und dabei gleichzeitig im Betrieb bzw. bei der Bewegung des Endeffektors die erforderlichen Informationen bereitstellen können.

Das Kameragehäuse 170 kann des Weiteren jeweils eine Beleuchtung 9 (z.B. LEDs) für das Sichtfeld der Kameras 161a, 161b umfassen. Die Beleuchtung 9 ist dabei vorzugsweise derart angeordnet, dass die Haupt-Abstrahlrichtung des Lichtes parallel zu der Blickrichtung der Kameras 161a, 161b verläuft.

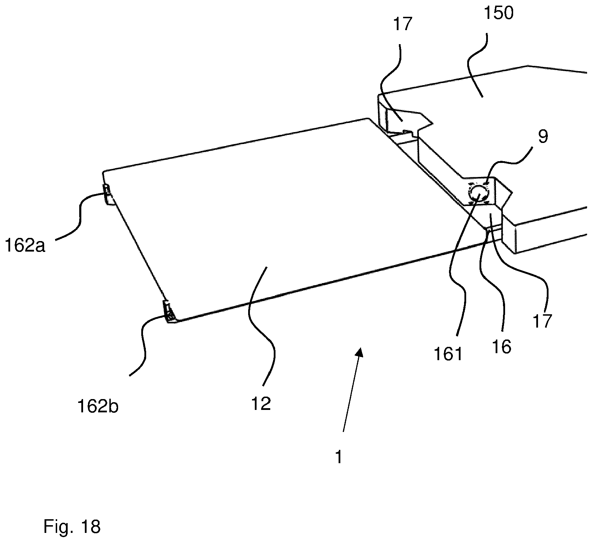

Fig. 18 zeigt ein Ausführungsbeispiel, bei welchem eine Kamera 161 mit integrierter Beleuchtung 9 im Endeffektor 150 integriert ist.

Hierzu umfasst der Träger des Endeffektors 150, aus welchem die Arme 162a, 162b hervorstehen, eine Einbuchtung 17, innerhalb der die Kamera 161 angeordnet ist. Die Kamera 161 ist bei dieser Ausführungsform der Erfindung schräg in das Gehäuse des Endeffektors 150 eingebaut.

So nimmt die Kamera 150, welche ein stabförmiges Gehäuse (nicht dargestellt) aufweisen kann, größtenteils ansonsten ungenutzten Raum im Gehäuse des Endeffektors 150 ein. Weiter kann durch die schräge Anordnung ein großes Sichtfeld bereitgestellt werden. Die optische Achse der Kamera 161 kann insbesondere einen Winkel von 30 bis 60° zur Haupterstreckungsrichtung der Arme 162a, 162b einnehmen.

Die zumindest eine Kamera 161 befindet sich in der Einbuchtung 17 in einer schräg verlaufenden Fläche, so dass die Kamera auf die Ecke 16 des Substrates 12 gerichtet ist.

Es versteht sich, dass in der zweiten Einbuchtung 17 vorzugsweise ebenfalls eine Kamera vorhanden ist oder sein kann, welche in dieser Ansicht verdeckt ist.

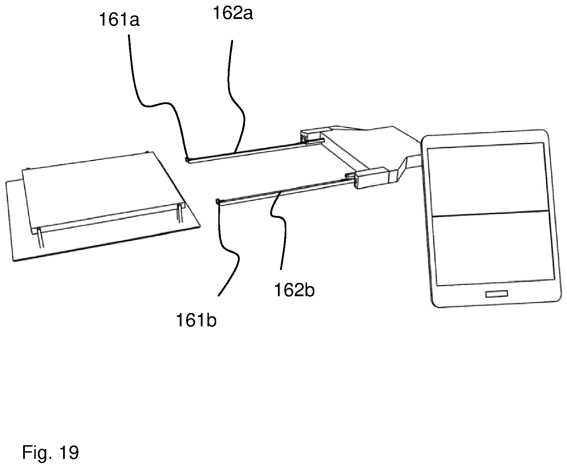

Fig. 19 zeigt eine weitere Ausführungsform der Erfindung, bei welcher die Kameras 161a, 161b an den Armen 162a, 162b des Endeffektors 150 angeordnet sind.

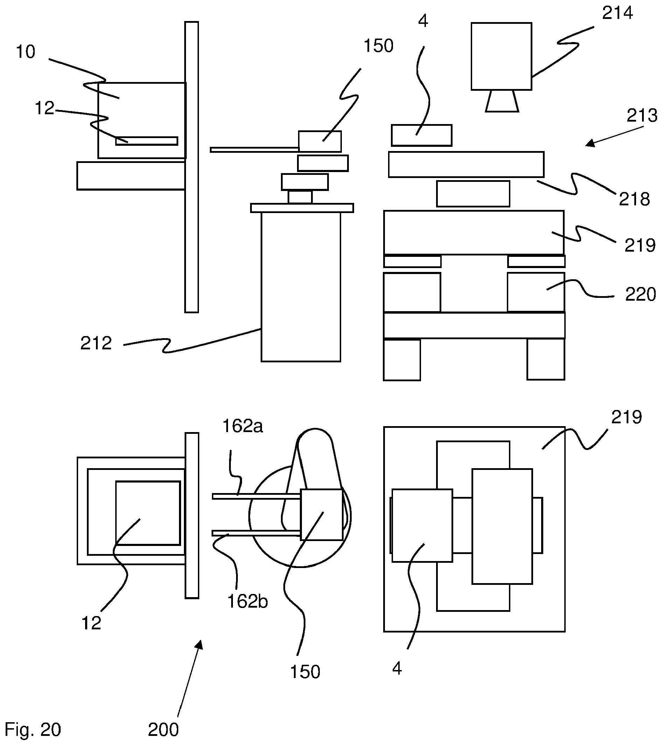

Fig. 20 zeigt in einer Seitenansicht und einer darunter dargestellten Draufsicht von oben wesentliche Bestandteile einer Maschine 200 der Halbleiterindustrie zur Prozessierung von Halbleiterbauelementen.

Die Maschine 200 umfasst einen Speicher 10, im Beispiel eine Kassette, für Substrate 12, im abgebildeten Fall für Masken, welcher im abgebildeten Fall insbesondere als FOUP ("front opening unified pod") abgebildet ist, welcher mit einem SMIF ("standard mechanical interface") Loadport geöffnet oder geschlossen wird.

Mittels eines Roboters 212 mit dem Endeffektor 150 können dem Speicher 10 Substrate 12 entnommen und an die Bearbeitungsstation 213 weitertransportiert werden.

Die Bearbeitungsstation 213 umfasst in diesem Ausführungsbeispiel eine verfahrbare Bühne 218 ("Stage"), auf welcher sich als Aufnahme für die Maske ein Chuck befindet.

Die hier darstelle Maschine zur Prozessierung von Masken kann insbesondere ein Inspektionsgerät 214 umfassen, welches sich auf einer Platte 219 befindet, die schwingungsisoliert von den Isolatoren 220 abgestützt wird.

Zumindest der Endeffektor 150 des Roboters 212 umfasst eine Kamera, mittels der der Roboter 212 im Betrieb Bilder erfassen kann und welche durch das künstliche neuronale Netz verarbeitet werden.

Hierdurch kann gleichzeitig die Belegung des Speichers 10 mit Substraten geprüft werden. Der Roboter 212 fährt so nur Aufnahmen an, in denen sich auch ein Substrat in einer gewünschten Position und Orientierung befindet. In dieser Darstellung befindet sich die dargestellte Anlage im Ruhezustand.

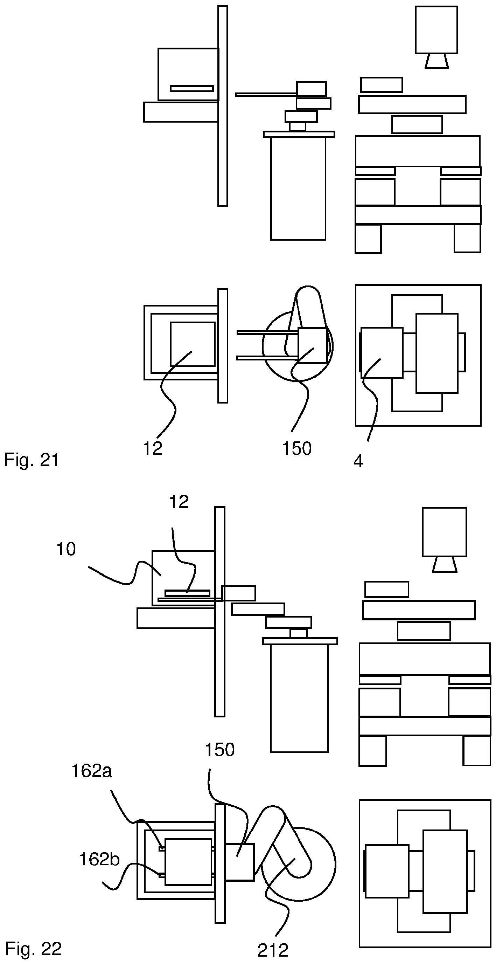

Fig. 21 zeigt die in Fig. 20 dargestellte Anlage im Ruhezustand. Wie in Fig. 20 dargestellt, wird zur Aufnahme des Substrates 12 bzw. der Maske aus dem Speicher 10 bzw. der Kassette der Endeffektor mit seinen Armen 162a, 162b unter die Maske gefahren.

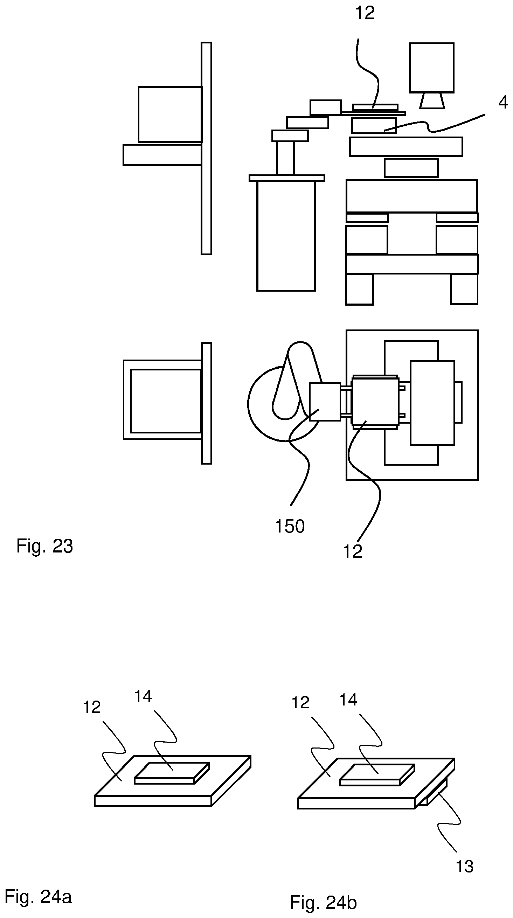

Die Maske wird mit dem Roboter 212 angehoben (Fig. 22) und in die Fig. 23 dargestellte Zielposition auf der Ablage 4 verfahren. Die Zielposition wird von der am Endeffektor angeordneten Kamera kontrolliert.

Die Maschine der Halbleiterindustrie kann auch eine Vakuumkammer enthalten. Es versteht sich, dass die erfindungsgemäßen Verfahren auch innerhalb von Vakuumkammern ausgeführt werden können, sofern die Komponenten, wie beispielsweise die Aufnahmeeinheit oder die Beleuchtung, soweit erforderlich, und/oder soweit sie sich innerhalb einer Vakuumkammer befinden, vakuumtauglich ausgeführt sind.

Beispielsweise über Clips kann die Aufnahmeeinheit 20 werkzeuglos installiert werden.

Mittels der Bilderkennung durch das künstliche neuronale Netz kann eine hochpräzise und effiziente Steuerung der Maschine der Halbleiterindustrie oder eines Endeffektors eines Roboters erreicht werden.

Das erfindungsgemäße Verfahren ermöglicht damit die Bearbeitung von Substraten, insbesondere von Wafern, Masken oder Flat Panel Displays.

Ergänzend kann vorgesehen sein, einen Endeffektor zu verwenden, bei welchem die Positionierung des Substrates, also der Masken, des Wafers oder des Flat Panel Displays, auf die Aufnahme durch im Endeffektor integrierte Motoren, beispielsweise mittels eines Piezos, erfolgt. So ist eine genauere Positionierung des Substrates möglich, als über den entfernten Antrieb im Roboter. Bei einer weiteren Ausführungsform der Erfindung umfasst also der Endeffektor selbst Aktoren zur Feinjustierung der Zielposition.

Hier kommen insbesondere die Vorteile bei einer Verwendung des künstlichen neuronalen Netzes zum Tragen, welche es ermöglichen, auch tolerierbare und einfach nachjustierbare Abweichungen von Soll-Lagen des Substrates, also Abweichungen von einem ideal abgelegten Substrat, zu erkennen und zu entscheiden, ob und unter welchen Anpassungen des Endeffektors eine Bearbeitung oder Prozessierung möglich ist.

Auch der Roboter selbst kann, wie es bei einer Ausführungsform der Erfindung vorgesehen ist, über die Bilderkennung in seinem Bewegungsablauf feinjustiert werden.

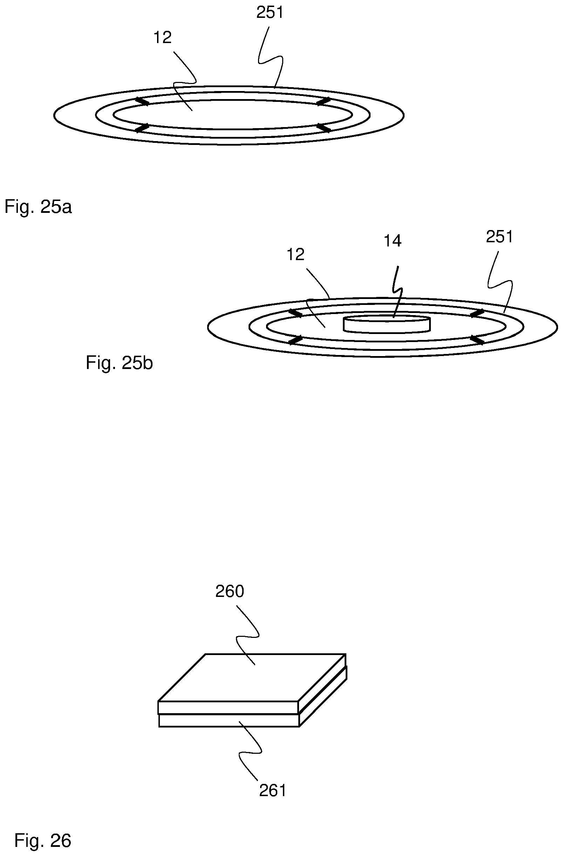

Fig. 24a, 24b zeigen jeweils ein Ausführungsbeispiel eines Substrates mit einem Aufbau am Beispiel einer Maske, und die Fig. 25a, 25b jeweils ein Ausführungsbeispiel eines Substrates mit einem Substrathalter am Beispiel eines Wafers, in einer Schrägsicht. Diese Ausführungsbeispiele sollen mögliche Aufbauten 14 eines Substrates 12 zeigen, welche erfindungsgemäß durch die Klassifikation des Typs des Substrate 12 erkannt werden können.

Fig. 24a zeigt schematisch ein Substrat 12, im Beispiel eine Maske, mit einem Aufbau 14; Fig. 24b die Maske aus Fig. 24a mit einem Aufbau 14 und einem Pellicle 13 unten quer.

Fig. 25a zeigt schematisch ein Substrat 12, im Beispiel einen Wafer, mit einem Substrathalter 251 zum Haltern des Substrates 12 bzw. Wafers; Fig. 25b die den Wafer aus Fig. 25a mit einem Aufbau 14. Ein Aufbau 14 kann beispielsweise eine Kalibriereinrichtung für die Maschine, ein Messmittel oder andere Bauteile umfassen.

Schließlich zeigt Fig. 26 eine Substrathalterung mit oberer Schale 260 und unterer Schale 261.

Das erfindungsgemäße Verfahren ermöglicht es damit gemäß einer Ausführungsform, dass das künstliche neuronale Netz auch Substrattypen erkennt, oder dass aus dem generierten Informationsdatensatz Substrattypen abgeleitet werden können, umfassend
ob das Substrat 12 einen Substrathalter 251 umfasst, und/oder
ob das Substrat 12 einen Aufbau 14 hat, und/oder
ob das Substrat 12 ein Pellicle 13 hat, und/oder
ob es sich bei dem Substrat 12 um einen Wafer handelt, und/oder
ob es sich bei dem Substrat 12 um eine Maske handelt, und/oder
ob es sich bei dem Substrat 12 um ein Flat Panel Display handelt.

Hierbei kann auch die Präsenz, und oder die Lage, und/oder die Orientierung, und/oder die Position des Substrates 12 und/oder des Substrattypen aus dem generierten Informationsdatensatz abgeleitet werden.

Ferner kann das künstliche neuronale Netz zur Erkennung der Substrattypen konfiguriert und angelernt sein oder werden, und den zur Erkennung oder Ableitung der Substrattypen erforderlichen Informationsdatensatz entsprechend ausgeben.

### Bezugszeichenliste:

- 1: Handlingsystem
- 4: Ablage
- 6: Tablet
- 8a, 8b: Ansicht
- 9: Beleuchtung

- 10: Speicher
- 11: Ablageort
- 12: Substrat
- 13: Pellicle
- 14: Aufbau
- 16: Ecke
- 17: Einbuchtung

- 20: Aufnahmeeinheit
- 21: Bildbereich

- 30: Gesamtbild
- 31a-f: Slot-Bilder

- 40: Rechnerarchitektur
- 41: Kabel
- 50: Beleuchtungseinheit

- 80: Handlingsystem
- 81: Endeffektor
- 82: Roboter
- 83: Roboter-Controller
- 84: Roboter-Handlingsystem
- 85: Systemcontroller
- 86: Maschine der Halbleiterindustrie
- 87: Steuerung
- 88: Rechner
- 89: Cloud
- 91: Roboter-System

- 100: Auflage
- 101: Aufnahmepunkte
- 102: Vorderseite der Auflage

- 110: diskreter Bereich einer Bilderkennung

- 120: Bildausschnitt
- 121: Substrat in Fehllage ("cross-slotted")
- 122: Substrat in Fehllage ("double-slotted")

- 130: Bildausschnitt

- 150: Endeffektor
- 151: Greifarm

- 160: Ablage
- 161a, 161b: Kamera
- 162a, 162b: Greifarm des Endeffektors

- 170: Kameragehäuse

- 200: Maschine
- 212: Roboter
- 213: Bearbeitungsstation
- 214: Inspektionsgerät
- 218: Bühne (Stage)
- 219: Platte
- 220: Isolator

- 251: Substrathalter

## Patentansprüche

1. Verfahren zur Bearbeitung von Substraten (12), insbesondere von Wafern, Masken oder Flat Panel Displays, mit einer Maschine der Halbleiterindustrie (86), wobei zum Bestimmen der Präsenz und/oder der Position und/oder der Orientierung und/oder des Typs eines Substrates (12) ein künstliches neuronales Netz verwendet wird,
um die Präsenz und/oder die Position und/oder die Orientierung und/oder des Typs des Substrates (12) zu ermitteln auf Basis von mindestens einem Bild, welches einen Ort in oder an der Maschine der Halbleiterindustrie (86) oder in der Umgebung der Maschine darstellt, an dem sich ein Substrat bei einem Betrieb der Maschine der Halbleiterindustrie (86) befinden kann,
wobei das mindestens eine Bild von mindestens einer Aufnahmeeinheit (20) aufgenommen wird,
und wobei durch das künstliche neuronale Netz
ein Informationsdatensatz umfassend eine Information über die ermittelte Präsenz und/oder Position und/oder Orientierung und/oder des Typs des Substrates (12) und/oder ein Steuerbefehl erzeugt wird und/oder ermöglicht wird, welcher dazu dient,
die Maschine der Halbleiterindustrie (86) direkt zu steuern, oder von der Steuerung der Maschine verwendet wird,
oder an ein übergeordnetes Steuerungssystem weitergegeben wird,
oder an einen Bediener weitergegeben wird, der aus dieser Information Rückschlüsse für sein Handeln zur Bedienung der Maschine zieht,
oder diese Information an Steuerungen oder andere Bediener weitergibt,
oder für spätere oder weitere Auswertung gespeichert wird.

2. Verfahren nach vorstehendem Anspruch 1, wobei das künstliche neuronale Netz mindestens ein Modell ausbildet, welches mindestens eine Faltungsebene (Convolutional Layer) und/oder mindestens einen Neuronenebene (Neuronal Layer) umfasst, und weitere Bestandteile, beispielsweise Aktivierungslayer, umfassen kann, und wobei das künstliche neuronale Netz angelernt werden kann, und/oder angelernte Daten aus einem vorangegangene Lernvorgang verwendet, und/oder wobei das künstliche neuronale Netz zumindest eine der Methoden der Regression, Machine-Learning oder Deep-Learning verwendet.

3. Verfahren nach einem der vorstehenden Ansprüche, wobei der Informationsdatensatz eine Information umfasst,
aus welcher die Präsenz des Substrates (12) in einem Slot, oder auf einer Auflage (100), oder auf einem Roboter (82), oder auf einem Endeffektor (81), oder auf einer Bearbeitungsstation in der Maschine, oder an einem anderen Ort, wo sich das Substrat (12) in der Maschine der Halbleiterindustrie (86) befinden kann,
und/oder die räumliche Orientierung des Substrates (12) in Bezug auf die zu einem Roboter (82) der Maschine gerichtete Seite eines Slots, oder in Bezug zu einer Auflage (100), oder im Bezug zu einer Bearbeitungsstation, oder im Bezug zu einem anderen Teil der Maschine,
und/oder die räumliche Lage des Substrates (12) zu einem Slot, oder zu einer Auflage (100), oder zu einem Roboter (82), oder zu einem Endeffektor (81), oder zu einem anderen Ort, wo sich das Substrat in der Maschine der Halbleiterindustrie (86) befinden kann,
und/oder den Typ des Substrates (12),
und/oder die Präsenz eines Pellicles (13) auf einem Substrat (12), insbesondere auf einer Maske,
und/oder die Seite eines abgelegten Substrates (12), insbesondere einer Maske, auf der sich ein Pellicle (13) befindet
und/oder die Orientierung eines Pellicles (13) in Bezug zu einer Referenzachse einer Auflage (100), einer Kassette, eines Roboters (82), eines Endeffektors (81),
und/oder die Präsenz und/oder die Position und/oder die Orientierung eines Substrates (12),
ermittelt werden kann oder ableitbar ist.

4. Verfahren nach einem der vorstehenden Ansprüche, wobei durch das künstliche neuronale Netz Fehllagen des Substrates (12) erkannt werden, umfassend
ob die Fehllage ein über mehrere Etagen einer Auflage (100) liegendes Substrat betrifft, und/oder
ob die Fehllage mindestens zwei direkt übereinander liegende Substrate (12) betrifft, und/oder
ob die Fehllage eine Abweichung von einer vorgegebenen Soll-Lage eines Substrates (12) betrifft, und/oder
ob die Fehllage ein nicht auf allen vorgesehenen Auflagepunkten einer Auflage (100) korrekt aufliegendes Substrat (12) betrifft.

5. Verfahren nach einem der vorstehenden Ansprüche, wobei das künstliche neuronale Netz Substrattypen erkennt, oder aus dem generierten Informationsdatensatz Substrattypen abgeleitet werden können, umfassend
ob das Substrat (12) einen Substrathalter hat, und/oder welchen Typ eines Substrathalters, und/oder
ob das Substrat (12) einen Aufbau hat, und/oder welchen Typ eines Aufbaus, und/oder ob das Substrat ein Pellicle (13) hat, und/oder
ob es sich bei dem Substrat (12) um einen Wafer handelt, und/oder
ob es sich bei dem Substrat (12) um eine Maske handelt, und/oder
ob es sich bei dem Substrat (12) im ein Flat Panel Display handelt,
wobei auch die Präsenz, und oder die Lage, und/oder die Orientierung, und/oder die Position des Substrates (12) und/oder des Substrattypen aus dem generierten Informationsdatensatz abgeleitet werden kann, und
wobei das künstliche neuronale Netzwerk zur Erkennung der Substrattypen konfiguriert und angelernt ist, und den zur Erkennung oder Ableitung der Substrattypen erforderlichen Informationsdatensatz ausgibt.

6. Verfahren nach einem der vorstehenden Ansprüche, wobei sich das Substrat (12) in Kassetten und/oder auf Auflagen (100) und/oder auf einem Endeffektor (81) und/oder auf einem Chuck und/oder auf einer Bearbeitungsstation der Maschine und/oder auf einer Verfahreinheit befinden kann oder befindet.

7. Verfahren nach einem der vorstehenden Ansprüche, wobei das zumindest eine Bild durch mindestens eine dauerhaft fest oder zeitweise fest in die Maschine integrierte, und/oder an die Maschine oder im Umfeld der Maschine angeordnete Aufnahmeeinheit (20) erzeugt wird, und/oder wobei die mindestens eine Aufnahmeeinheit (20) in Bezug auf die Maschine ortsunveränderlich installiert ist, und/oder sich an beweglichen Elementen der Maschine befindet, bevorzugt an einem Roboterarm oder an einem Endeffektor (81) eines Roboters (82) oder an einer Verfahreinheit.

8. Verfahren nach einem der vorstehenden Ansprüche, wobei die Aufnahmeeinheit (20) einen optischen Sensor, einen Ultraschall-Sensor, einen Abstands-Sensor, einen Reflex-Sensor, ein Radar-Sensor, eine bildgebende Kamera oder Video-Kamera, oder eine Infrarotkamera umfasst.

9. Verfahren nach einem der vorstehenden Ansprüche, wobei zwei Aufnahmeeinheiten (20), insbesondere zwei Kameras, vorgesehen sind, welche sich vorne an einem Endeffektor (81) befinden, wobei die optischen Achsen der beiden Aufnahmeeinheiten (20) parallel oder in einem Winkel zueinander stehen, welcher zwischen 5° und 90°, bevorzugt zwischen 10° und 80° und besonders bevorzugt zwischen 15° und 75° beträgt.

10. Verfahren nach einem der vorstehenden Ansprüche, wobei durch das künstliche neuronale Netz mehr als ein Bild erfasst wird, insbesondere zumindest zwei Bilder, vorzugsweise des gleichen Ortes, welche von unterschiedlichen Aufnahmeeinheiten (20) und/oder unterschiedlich angeordneten Aufnahmeeinheiten (20) erzeugt wurden.

11. Verfahren nach einem der vorstehenden Ansprüche, wobei nach Erzeugen des Informationsdatensatzes in einem weiteren zweiten Schritt mindestens ein Merkmal mittels eines weiteren Verfahrens zur Bilderkennung analysiert wird, beispielsweise eines regelbasierenden Verfahrens oder ein Verfahren zur Kantenerkennung, oder mittels eines Sensors.

12. Verfahren nach einem der vorstehenden Ansprüche, wobei eine Beleuchtungseinrichtung vorgesehen ist, welche dazu ausgebildet ist, elektromagnetische Strahlung in Richtung auf das Substrat (12) oder den Ort in oder an der Maschine zu emittieren, vorzugsweise wenn ein Bild erfasst wird, wobei die elektromagnetische Strahlung bevorzugt zumindest im sichtbaren Wellenlängenbereich liegt und/oder in einem Wellenlängenbereich, in dem die Aufnahmeeinheit (20) sensitiv ist, wobei vorzugsweise die Beleuchtungseinrichtung in die Maschine dauerhaft fest oder zeitweise fest integriert und/oder an der Maschine angebaut ist, wobei die Beleuchtungseinrichtung in Bezug auf die Maschine ortsunveränderlich installiert ist, und/oder wobei sich die Beleuchtungseinrichtung an beweglichen Elementen der Maschine befindet, bevorzugt an einem Roboterarm oder an einem Endeffektor (81) eines Roboters (82) oder an einer Verfahreinheit.

13. Verfahren nach einem der vorstehenden Ansprüche, wobei das künstliche neuronale Netz in eine Verarbeitungseinheit als Komponente einer Rechnerarchitektur aufgenommen ist, und wobei die Rechnerarchitektur ferner zumindest eine Komponente für Rechner-Hardware und für ein Betriebssystem des Rechners umfasst.

14. Verfahren nach einem der vorstehenden Ansprüche, wobei zumindest die Komponenten Verarbeitungseinheit, Rechner-Hardware und Betriebssystem in einem System-Controller
der Maschine der Halbleiterindustrie integriert ist
oder in einen Roboter (82) oder in einem Endeffektor (81) eines Roboters (82),
oder in einem Roboter-Controller,
oder in einer Steuerung der Maschine,
oder in einer zur Maschine übergeordneten Steuerung,
oder in einer der Maschine nicht zugeordneten Steuerung, bevorzugt in einer Cloud,
oder ein einem anderen Rechner an einem beliebigen weltweiten Standort.

15. Verfahren nach dem vorstehenden Anspruch, wobei zumindest die Komponenten Verarbeitungseinheit, Rechner-Hardware und Betriebssystem an zumindest zwei verschiedenen Stellen angeordnet ist, und wobei
das künstliche neuronale Netz und/oder die Anwendung des künstlichen neuronalen Netzes über mehr als einen dieser Stellen verteilt ablaufen, oder
wobei das Trainieren des künstlichen neuronalen Netzes auf einer anderen, weiteren Rechnerarchitektur durchgeführt wird als die Anwendung des künstlichen neuronalen Netzes.

16. Verfahren zum Bereitstellen eines angelernten oder trainierten künstlichen neuronalen Netzes zur Verwendung in einem Verfahren nach einem der vorstehenden Ansprüche, umfassend die Schritte:
Bereitstellen einer Verarbeitungseinheit, welche zumindest ein künstliches neuronales Netz, vorzugsweise zur Bildverarbeitung, aufweist oder umfasst,
Trainieren des künstlichen neuronalen Netzes durch Erfassen und Bereitstellen von zumindest einem Bild, bevorzugt einer Vielzahl von wenigstens 20 Bildern, wenigstens 100, besonders bevorzugt wenigstens 1.000 Bildern, wobei vorzugsweise eine Vielzahl von wenigstens zwei Bildern für das Trainieren und Anlernen erfasst und/oder bereitgestellt werden, welche sich in der Ausprägung zumindest eines Parameters oder Einflussfaktors unterscheiden.

17. Verfahren zum Bereitstellen eines angelernten oder trainierten künstlichen neuronalen Netzes nach vorstehendem Anspruch, mit zumindest einer unterschiedlichen Ausprägung in mindestens einem der folgenden Parametern:
- die Präsenz des Substrates (12) an einem Ort
- der Typ des Substrates (12)
- die Lage des Substrates (12) in Bezug auf eine Soll-Lage
- die Orientierung des Substrates (12) in Bezug auf eine Referenz in der Maschine
- die Anzahl der Substrate (12) im Slot und/oder in der Kassette insgesamt
- die Farbe und/oder das Transmissionsverhalten des Substrates,
- die Abmessungen des Substrates (12),
- die Beschaffenheit der Kanten des Substrates (12),
- das Vorhandensein von Erkennungsmarken,
- die Beschaffenheit der Oberfläche des Substrates (12),
- das Vorhandensein eines Pellicle (13) sowie Ort, Lage und Orientierung des Pellicle (13) in Bezug auf das Substrat (12),
- die Beleuchtungsverhältnisse (Lichtstärke und/oder Lichtrichtung)
- die Art, die Farbe und/oder die Beschaffenheit des Hintergrundes,
- die Bildschärfe,
- die Fokussierung,
- die Reflektion anderer Objekte auf das Substrat (12),
- Lichteinstreuung aus der Umgebung
und Trainieren des künstlichen neuronalen Netzes anhand einer Kategorisierung oder Klassifikation der Bilder.

18. Verfahren nach einem der vorstehenden Ansprüche 16 oder 17, wobei während der Anwendung des künstlichen neuronalen Netzes in der Maschine der Halbleiterindustrie (86) Bilder erfasst und gespeichert werden, um diese in mindestens einem initialen oder mindestens einem neuen Lernprozess zur Verbesserung des Ergebnisses des künstlichen neuronalen Netzes zu verwenden.

19. Verfahren nach einem der vorstehenden Ansprüche, wobei die Maschine Mittel zum Greifen, Haltern, Transportieren und/oder Ablagen eines Substrates (12) umfasst, bevorzugt einen Roboter (82), besonders bevorzugt umfassend ein bewegliches Element oder einen Roboterarm und/oder einen Endeffektor (81), oder eine Verfahreinheit.

20. System zur Bearbeitung von Substraten (12), insbesondere von Wafern, Masken oder Flat Panel Displays, ausgebildet zur Ausführung eines Verfahrens nach einem der vorstehenden Ansprüche, wobei das System vorzugsweise umfasst:
eine Maschine der Halbleiterindustrie (86), ein Roboter (82), ein bewegliches Element, bevorzugt ein Roboterarm und/oder ein Endeffektor (81), oder eine Verfahreinheit, eine Verarbeitungseinheit, welche zumindest ein trainiertes künstliches neuronales Netz umfasst, und
eine Aufnahmeeinheit (20) zum Erfassen zumindest eines Bildes.

21. Computerprogrammprodukt, welches direkt in einem Speicher einer Verarbeitungseinheit des Systems nach einem der beiden vorstehenden Ansprüche ladbar ist, mit Programmcode-Mitteln, um ein Verfahren nach einem der Ansprüche 1 bis 17 auszuführen, wenn das Computerprogrammprodukt in der Verarbeitungseinheit ausgeführt wird.

## Claims

1. A method for processing substrates (12), in particular wafers, masks or flat panel displays, using a semiconductor industry machine (86), wherein an artificial neural network is used for determining the presence and/or the location and/or the orientation and/or the type of a substrate (12);
for determining the presence and/or the position and/or the orientation and/or the type of the substrate (12) on the basis of at least one image that shows a location in or on the semiconductor industry machine (86) or in the vicinity of the machine, where a substrate can be located during operation of the semiconductor industry machine (86);
wherein the at least one image is captured by at least one capturing unit (20);
and wherein the artificial neural network is used to
generate an information dataset comprising a piece of information about the determined presence and/or position and/or orientation and/or type of the substrate (12) and/or to generate and/or enable a control command which is used for
directly controlling the semiconductor industry machine (86), or is used by the machine controller;
or is forwarded to a higher-level control system;
or is forwarded to an operator who draws conclusions from this piece of information for his actions to operate the machine,
or forwards this piece of information to controllers or other operators,
or is stored for later or further evaluation.

2. The method according to the preceding claim 1, wherein the artificial neural network forms at least one model which comprises at least one convolutional layer and/or at least one neuronal layer, and may comprise further components such as an activation layer, and wherein the artificial neural network can be trained, and/or uses learned data from a previous training process, and/or wherein the artificial neural network uses at least one technique of the group consisting of regression, machine learning, and deep learning.

3. The method according to any one of the preceding claims, wherein the information dataset comprises a piece of information which allows to identify or derive:
the presence of the substrate (12) in a slot, or on a support (100), or on a robot (82), or on an end effector (81), or on a processing station in the machine, or at another location where the substrate (12) may be located within the semiconductor industry machine (86);
and/or the spatial orientation of the substrate (12) with respect to the side of a slot facing a robot (82) of the machine, or with respect to a support (100), or with respect to a processing station, or with respect to another part of the machine;
and/or the spatial position of the substrate (12) with respect to a slot, or to a support (100), or to a robot (82), or to an end effector (81), or to another location where the substrate may be located within the semiconductor industry machine (86);
and/or the type of the substrate (12);
and/or the presence of a pellicle (13) on a substrate (12), in particular on a mask;
and/or the side of a deposited substrate (12), in particular of a mask on which a pellicle (13) is provided;
and/or the orientation of a pellicle (13) with respect to a reference axis of a support (100), a cassette, a robot (82), an end effector (81);
and/or the presence and/or the position and/or the orientation of a substrate (12).

4. The method according to any one of the preceding claims, wherein the artificial neural network is used to detect incorrect positions of the substrate (12), including
whether the incorrect position relates to a substrate lying over multiple levels of a support (100), and/or
whether the incorrect position relates to at least two substrates (12) lying directly one above the other; and/or
whether the incorrect position relates to a deviation from a specified target position of a substrate (12); and/or
whether the incorrect position relates to a substrate (12) that does not correctly rest on all intended support points of a support (100).

5. The method according to any one of the preceding claims, wherein the artificial neural network identifies substrate types, or wherein substrate types can be derived from the generated information dataset, including
whether the substrate (12) has a substrate holder, and/or what type of substrate holder; and/or
whether the substrate (12) has a structure, and/or what type of structure; and/or
whether the substrate has a pellicle (13); and/or
whether the substrate (12) is a wafer; and/or
whether the substrate (12) is a mask; and/or
whether the substrate (12) is a flat panel display,
wherein the presence and/or the location and/or the orientation and/or the position of the substrate (12) and/or the substrate type can also be derived from the generated information dataset; and
wherein the artificial neural network is configured and trained for identifying the substrate types and outputs the information dataset required for identifying or deriving the substrate types.

6. The method according to any one of the preceding claims, wherein the substrate (12) can be or is located in cassettes, and/or on supports (100), and/or on an end effector (81), and/or on a chuck, and/or on a processing station of the machine, and/or on a transfer unit.

7. The method according to any one of the preceding claims, wherein the at least one image is generated by at least one capturing unit (20) that is permanently or temporarily firmly integrated into the machine and/or is arranged on the machine or in the vicinity of the machine; and/or wherein the at least one capturing unit (20) is installed in a stationary manner with respect to the machine and/or is located on movable members of the machine, preferably on a robot arm or on an end effector (81) of a robot (82), or on a transfer unit.

8. The method according to any one of the preceding claims, wherein the capturing unit (20) comprises an optical sensor_and/or an ultrasonic sensor_and/or a distance sensor_and/or a reflex sensor_and/or a radar sensor_and/or an imaging camera or video camera, or an infrared camera.

9. The method according to any one of the preceding claims, wherein two capturing units (20) are provided, in particular two cameras, which are located at the front end of an end effector (81), wherein the optical axes of the two capturing units (20) are parallel to one another or enclose an angle which is between 5° and 90°, preferably between 10° and 80°, and most preferably between 15° and 75°.

10. The method according to any one of the preceding claims, wherein the artificial neural network captures more than one image, in particular at least two images, preferably of the same location, which were generated by different capturing units (20) and/or by differently arranged capturing units (20).

11. The method according to any one of the preceding claims, wherein, after generating the information dataset, a further, second step comprises analysing at least one feature by a further image recognition technique, for example by a rule-based technique or an edge detection technique, or by means of a sensor.

12. The method according to any one of the preceding claims, wherein an lighting device is provided, which is adapted to emit electromagnetic radiation towards the substrate (12) or the location in or on the machine, preferably when an image is captured, wherein the electromagnetic radiation is preferably at least in the visible wavelength range and/or in a wavelength range in which the capturing unit (20) is sensitive, wherein the lighting device is preferably permanently or temporarily firmly integrated into the machine and/or is mounted to the machine, wherein the lighting device is installed stationary with respect to the machine, and/or wherein the lighting device is located on movable members of the machine, preferably on a robot arm or on an end effector (81) of a robot (82), or on a transfer unit.

13. The method according to any one of the preceding claims, wherein the artificial neural network is included in a processing unit as a component of a computer architecture, and wherein the computer architecture furthermore comprises at least one component for computer hardware and for an operating system of the computer.

14. The method according to any one of the preceding claims, wherein at least the
components processing unit, computer hardware and operating system are integrated in a system controller of the semiconductor industry machine;
or in a robot (82) or in an end effector (81) of a robot (82);
or in a robot controller;
or in a control device of the machine;
or in a control device at a higher level than the machine;
or in a control device that is not assigned to the machine, preferably in a cloud;
or on another computer at any global location.

15. The method according to the preceding claim, wherein at least the components processing unit, computer hardware and operating system are located in at least two different locations; and wherein the artificial neural network and/or the application of the artificial neural network are executed in a distributed manner at more than one of these locations; or
wherein the training of the artificial neural network is performed on a different, further computer architecture than the application of the artificial neural network.

16. A method for providing a learned or trained artificial neural network for use in a method according to any one of the preceding claims, comprising the steps of:
providing a processing unit which has or comprises at least one artificial neural network, preferably for image processing;
training the artificial neural network by capturing and providing at least one image, preferably a plurality of at least 20 images, at least 100, most preferably at least 1,000 images, wherein preferably a plurality of at least two images which differ in the expression of at least one parameter or influencing factor are captured and/or provided for the training and learning.

17. The method for providing a learned or trained artificial neural network according to the preceding claim, with at least one different expression in at least one of the following parameters:
- the presence of the substrate (12) at a location;
- the type of substrate (12)_;
- the position of the substrate (12) with respect to a target position;
- the orientation of the substrate (12) with respect to a reference in the machine;
- the total number of substrates (12) in the slot and/or in the cassette;
- the colour and/or the transmittance behaviour of the substrate;
- the dimensions of the substrate (12);
- the nature of the edges of the substrate (12);
- the presence of identification tags;
- the nature of the surface of the substrate (12);
- the presence of a pellicle (13) and the location, position and orientation of the pellicle (13) in relation to the substrate (12);
- the lighting conditions (light intensity and/or light direction)
- the type, colour and/or nature of the background,
- the sharpness of the image;
- the focus;
- the reflection of other objects on the substrate (12);
- light scattering from the environment;
and training the artificial neural network on the basis of a categorization or classification of the images.

18. The method according to any one of the preceding claims 16 or 17, wherein images are captured and stored during the application of the artificial neural network in the semiconductor industry machine (86), in order to use them in at least one initial or at least one new learning process to improve the result of the artificial neural network.

19. The method according to any one of the preceding claims, wherein the machine comprises means for gripping, holding, transferring and/or depositing a substrate (12), preferably a robot (82), particularly preferably comprising a movable member or a robot arm and/or an end effector (81), or a transfer unit.

20. A system for processing substrates (12), in particular wafers, masks or flat panel displays, configured for executing a method according to any one of the preceding claims, wherein the system preferably comprises:
a semiconductor industry machine (86), a robot (82), a movable member, preferably a robot arm and/or an end effector (81), or a transfer unit, a processing unit, which comprises at least one trained artificial neural network; and
a capturing unit (20) for capturing at least one image.

21. A computer program product which can directly be uploaded into a memory of a
processing unit of the system according to any one of the two preceding claims, comprising program code means for executing a method according to any one of claims 1 to 17 when the computer program product is executed in the processing unit.

## Revendications

1. - Procédé de traitement de substrats (12), en particulier de plaquettes, de masques ou de panneaux d'affichage plats, avec une machine de l'industrie des semi-conducteurs (86), dans lequel on utilise un réseau neuronal artificiel pour déterminer la présence et/ou la position et/ou l'orientation et/ou le type d'un substrat (12),
pour déterminer la présence et/ou la position et/ou l'orientation et/ou le type du substrat (12) sur la base d'au moins une image, laquelle représente un endroit dans ou sur la machine de l'industrie des semi-conducteurs (86) ou dans l'environnement de la machine, sur laquelle un substrat peut se trouver lors d'une exploitation de la machine de l'industrie des semi-conducteurs (86),
dans lequel ladite au moins une image est capturée par au moins une unité de capture (20),
et dans lequel, par le réseau neuronal artificiel, un ensemble de données d'information comportant une information sur la présence et/ou la position et/ou l'orientation et/ou le type déterminé du substrat (12) et/ou une instruction de commande est généré et/ou rendu possible, lequel sert à
commander directement la machine de l'industrie des semi-conducteurs (86), ou est utilisé par la commande de la machine,
ou est transmis à un système de commande de niveau supérieur,
ou est transmis à un opérateur qui tire de cette information des conclusions pour son action pour la commande de la machine,
ou communique cette information aux commandes ou à d'autres opérateurs,
ou est mémorisé en vue d'une évaluation ultérieure ou autre.

2. - Procédé selon la revendication 1, dans lequel le réseau neuronal artificiel forme au moins un modèle, lequel comporte au moins une couche de convolution et/ou au moins une couche neuronale, et peut comporter d'autres composants, par exemple une couche d'activation, et dans lequel le réseau neuronal artificiel peut être spécialisé et/ou utilise des données spécialisées à partir d'un processus d'apprentissage précédent, et/ou dans lequel le réseau neuronal artificiel utilise au moins l'une des méthodes de régression, apprentissage automatique ou apprentissage profond.

3. - Procédé selon l'une des revendications précédentes, dans lequel l'ensemble de données d'information comporte une information,
à partir de laquelle la présence du substrat (12) dans un emplacement, ou sur un support (100), ou sur un robot (82), ou sur un effecteur terminal (81), ou sur un poste de traitement dans la machine, ou à un autre endroit où le substrat (12) peut se trouver dans la machine de l'industrie des semi-conducteurs (86),
et/ou l'orientation spatiale du substrat (12) par rapport au côté d'un emplacement orienté vers un robot (82) de la machine, ou par rapport à un support (100), ou par rapport à un poste de traitement, ou par rapport à une autre partie de la machine,
et/ou la position spatiale du substrat (12) par rapport à un emplacement, ou à un support (100), ou à un robot (82), ou à un effecteur terminal (81), ou à un autre endroit où le substrat peut se trouver dans la machine de l'industrie des semi-conducteurs (86),
et/ou le type de substrat (12),
et/ou la présence d'une pellicule (13) sur un substrat (12), en particulier sur un masque,
et/ou le côté d'un substrat déposé (12), en particulier d'un masque, sur lequel se trouve une pellicule (13),
et/ou l'orientation d'une pellicule (13) par rapport à un axe de référence d'un support (100), d'une cassette, d'un robot (82), d'un effecteur terminal (81),
et/ou la présence et/ou la position et/ou l'orientation d'un substrat (12),
peut être déterminé ou peut être déduit.

4. - Procédé selon l'une des revendications précédentes, dans lequel par le réseau neuronal artificiel, des erreurs de positionnement du substrat (12) sont détectées, comportant
si l'erreur de positionnement concerne un substrat situé sur plusieurs étages d'un support (100), et/ou
si l'erreur de positionnement concerne au moins deux substrats (12) directement superposés, et/ou
si l'erreur de positionnement concerne un écart par rapport à un emplacement de consigne prédéfini d'un substrat (12), et/ou
si l'erreur de positionnement concerne un substrat (12) ne reposant pas correctement sur tous les points d'appui prévus d'un support (100).

5. - Procédé selon l'une des revendications précédentes, dans lequel le réseau neuronal artificiel reconnaît des types de substrat, ou des types de substrat peuvent être déduits de l'ensemble de données d'information généré, comportant
si le substrat (12) a un porte-substrat, et/ou quel type d'un porte-substrat, et/ou
si le substrat (12) a une structure, et/ou quel type d'une structure, et/ou si le substrat a une pellicule (13), et/ou
si le substrat (12) est une plaquette, et/ou
si le substrat (12) est un masque, et/ou
si le substrat (12) est un panneau d'affichage plat,
dans lequel la présence, et/ou l'emplacement, et/ou l'orientation, et/ou la position du substrat (12) et/ou des types de substrat peut également être déduit de l'ensemble de données d'information généré, et
dans lequel le réseau neuronal artificiel est configuré et entraîné à reconnaître les types de substrat, et délivre l'ensemble de données d'information nécessaire pour reconnaître ou déduire les types de substrat.

6. - Procédé selon l'une des revendications précédentes, dans lequel le substrat (12) peut se trouver ou se trouve dans des cassettes et/ou sur des supports (100) et/ou sur un effecteur terminal (81) et/ou sur un mandrin et/ou sur un poste de traitement de la machine et/ou sur une unité de déplacement.

7. - Procédé selon l'une des revendications précédentes, dans lequel ladite au moins une image est produite par au moins une unité de capture (20) intégrée fermement de manière durable ou fermement de manière temporaire dans la machine, et/ou disposée sur la machine ou dans l'environnement de la machine, et/ou dans lequel ladite au moins une unité de capture (20) est installée de manière immobile par rapport à la machine, et/ou se trouve sur des éléments mobiles de la machine, de préférence sur un bras de robot ou sur un effecteur terminal (81) d'un robot (82) ou sur une unité de déplacement.

8. - Procédé selon l'une des revendications précédentes, dans lequel l'unité de capture (20) comporte un capteur optique, un capteur à ultrasons, un capteur de distance, un capteur réflexe, un capteur radar, une caméra d'imagerie ou une caméra vidéo, ou une caméra infrarouge.

9. - Procédé selon l'une des revendications précédentes, dans lequel deux unités de capture (20), en particulier deux caméras, sont prévues, lesquelles se trouvent à l'avant d'un effecteur terminal (81), les axes optiques des deux unités de capture (20) étant parallèles ou formant entre eux un angle, lequel est compris entre 5° et 90°, de préférence entre 10° et 80° et de manière particulièrement préférée entre 15° et 75°.

10. - Procédé selon l'une des revendications précédentes, dans lequel par le réseau neuronal artificiel, plus d'une image est collectée, en particulier au moins deux images, de préférence du même endroit, lesquelles ont été générées par des unités de capture (20) différentes et/ou des unités de capture (20) disposées différemment.

11. - Procédé selon l'une des revendications précédentes, dans lequel, après la génération de l'ensemble de données d'information, dans une deuxième étape supplémentaire, au moins une caractéristique est analysée au moyen d'un autre procédé de reconnaissance d'image, par exemple d'un procédé basé sur des règles ou un procédé de reconnaissance des bords, ou au moyen d'un capteur.

12. - Procédé selon l'une des revendications précédentes, dans lequel un dispositif d'éclairage est prévu, lequel est conçu pour émettre un rayonnement électromagnétique en direction du substrat (12) ou de l'endroit dans ou sur la machine, de préférence lorsqu'une image est collectée, le rayonnement électromagnétique se situant de préférence au moins dans la plage des longueurs d'onde visibles et/ou dans une plage de longueurs d'onde dans laquelle l'unité de capture (20) est sensible, de préférence, le dispositif d'éclairage étant intégré de manière fixe durablement ou de manière fixe temporairement dans la machine et/ou étant monté sur la machine, le dispositif d'éclairage étant installé de manière immobile par rapport à la machine, et/ou le dispositif d'éclairage se trouvant sur des éléments mobiles de la machine, de préférence sur un bras de robot ou sur un effecteur terminal (81) d'un robot (82) ou sur une unité de déplacement.

13. - Procédé selon l'une des revendications précédentes, dans lequel le réseau neuronal artificiel est incorporé dans une unité de traitement en tant que composant d'une architecture informatique, et dans lequel l'architecture informatique comporte en outre au moins un composant pour du matériel informatique et pour un système d'exploitation de l'ordinateur.

14. - Procédé selon l'une des revendications précédentes, dans lequel au moins les composants unité de traitement, matériel informatique et système d'exploitation sont intégrés dans un contrôleur de système de la machine de l'industrie des semi-conducteurs
ou dans un robot (82) ou dans un effecteur terminal (81) d'un robot (82),
ou dans un contrôleur de robot,
ou dans une commande de la machine,
ou dans une commande de niveau supérieur à la machine,
ou dans un système de commande non affecté à la machine, de préférence dans un nuage,
ou dans un autre ordinateur dans n'importe quel endroit du monde.

15. - Procédé selon la revendication précédente, dans lequel au moins les
composants unité de traitement, matériel informatique et système d'exploitation sont disposés en au moins deux sites différents, et
le réseau neuronal artificiel et/ou l'application du réseau neuronal artificiel fonctionnant de manière répartie sur plus d'un de ces sites ; ou
l'entraînement du réseau neuronal artificiel étant effectué sur une architecture informatique différente autre que l'application du réseau neuronal artificiel.

16. - Procédé pour fournir un réseau neuronal artificiel spécialisé ou entraîné pour l'utilisation dans un procédé selon l'une des revendications précédentes, comportant les étapes consistant à :
fournir une unité de traitement, laquelle présente ou comporte au moins un réseau neuronal artificiel, de préférence pour le traitement d'images,
entraîner le réseau neuronal artificiel par la capture et la fourniture d'au moins une image, de préférence d'une pluralité d'au moins 20 images, d'au moins 100, de manière particulièrement préférée d'au moins 1000 images, une pluralité d'au moins deux images étant de préférence capturée et/ou fournie pour l'entraînement et la spécialisation, lesquelles se distinguent par l'expression d'au moins un paramètre ou facteur d'influence.

17. - Procédé pour fournir un réseau neuronal artificiel spécialisé ou entraîné selon la revendication précédente, avec au moins une expression différente dans au moins l'un des paramètres suivants :
- la présence du substrat (12) dans un endroit
- le type de substrat (12)
- l'emplacement du substrat (12) par rapport à un emplacement de consigne,
- l'orientation du substrat (12) par rapport à une référence dans la machine,
- le nombre des substrats (12) dans l'emplacement et/ou dans la cassette au total,
- la couleur et/ou la transmissivité du substrat,
- les dimensions du substrat (12),
- la nature des bords du substrat (12),
- la présence de marques d'identification,
- la nature de la surface du substrat (12),
- la présence d'une pellicule (13) ainsi que l'endroit, l'emplacement et l'orientation de la pellicule (13) par rapport au substrat (12),
- les conditions d'éclairage (intensité lumineuse et/ou direction de la lumière)
- le type, la couleur et/ou la nature du fond,
- la netteté de l'image,
- la focalisation,
- la réflexion d'autres objets sur le substrat (12),
- l'interférence de lumière provenant de l'environnement
et l'entraînement du réseau neuronal artificiel à partir d'une catégorisation ou d'une classification des images.

18. - Procédé selon l'une des revendications précédentes 16 ou 17, dans lequel, pendant l'application du réseau neuronal artificiel dans la machine de l'industrie des semi-conducteurs (86), des images sont capturées et mémorisées pour être utilisées dans au moins un processus d'apprentissage initial ou au moins un nouveau processus d'apprentissage pour améliorer le résultat du réseau neuronal artificiel.

19. - Procédé selon l'une des revendications précédentes, dans lequel la machine comporte des moyens pour saisir, maintenir, transporter et/ou déposer un substrat (12), de préférence un robot (82), de manière particulièrement préférée comportant un élément mobile ou un bras de robot et/ou un effecteur terminal (81), ou une unité de déplacement.

20. - Système de traitement de substrats (12), en particulier de plaquettes, de masques ou de panneaux d'affichage plats, conçu pour la mise en oeuvre d'un procédé selon l'une des revendications précédentes, le système comportant de préférence :
une machine de l'industrie des semi-conducteurs (86), un robot (82), un élément mobile, de préférence un bras de robot et/ou un effecteur terminal (81), ou une unité de déplacement,
une unité de traitement, laquelle comporte au moins un réseau neuronal artificiel entraîné, et
une unité de capture (20) pour la capture d'au moins une image.

21. - Produit programme d'ordinateur, lequel est chargeable directement dans une mémoire d'une unité de traitement du système selon l'une des deux revendications précédentes, comportant des moyens de code de programme pour mettre en oeuvre un procédé selon l'une des revendications 1 à 17, lorsque le produit programme d'ordinateur est exécuté dans l'unité de traitement.
